(19) Europäisches Patentamt
European Patent Office
Office européen des brevets

(11) EP 2 754 086 B1

(12) EUROPÄISCHE PATENTSCHRIFT

(45) Veröffentlichungstag und Bekanntmachung des Hinweises auf die Patenterteilung:
**17.04.2019 Patentblatt 2019/16**

(21) Anmeldenummer: **12769597.1**

(22) Anmeldetag: **05.09.2012**

(51) Int Cl.:
***G06K 7/00*** *(2006.01)*

(86) Internationale Anmeldenummer:
**PCT/EP2012/003728**

(87) Internationale Veröffentlichungsnummer:
**WO 2013/034293 (14.03.2013 Gazette 2013/11)**

(54) **VERFAHREN ZUM PRÜFEN EINER ANTENNENSPULE**

METHOD FOR TESTING AN ANTENNA COIL

METHODE POUR TESTER UNE BOBINE D'ANTENNE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **08.09.2011 DE 102011112873**

(43) Veröffentlichungstag der Anmeldung:
**16.07.2014 Patentblatt 2014/29**

(73) Patentinhaber: **Giesecke+Devrient Mobile Security GmbH**
**81677 München (DE)**

(72) Erfinder:
• **BALDISCHWEILER, Michael**
**81825 München (DE)**
• **FINKENZELLER, Klaus**
**85774 Unterföhring (DE)**
• **BOHN, Carsten**
**81667 München (DE)**

(56) Entgegenhaltungen:
**DE-A1- 10 117 249    DE-A1-102008 004 772**

**Beschreibung**

Die vorliegende Erfindung betrifft ein Verfahren zum Prüfen der Funktionsfähigkeit einer Antennenspule für einen portablen Datenträger, eine entsprechende Prüfvorrichtung sowie eine Vorrichtung zur Herstellung einer Antennenspule.

Portable Datenträger, wie beispielsweise ein Personalausweis, ein Reisepass, eine Kreditkarte, ein Label zur Warensicherung oder dergleichen, können mit einer Antennenspule zur kontaktlosen Datenkommunikation mit einem Lesegerät ausgestattet sein. Die Antennenspule ist dazu in der Regel mit einem integrierten Schaltkreis des Datenträgers, insbesondere einem Chip, verbunden und auf einer Träger- oder Inlayschicht, beispielsweise aus einem Kunststoffmaterial wie PC oder PVC, eines Datenträgerkörpers des Datenträgers aufgebracht, beispielsweise aufgedruckt.

Um die Funktionsfähigkeit einer Antennenspule während oder nach der Herstellung des entsprechenden Datenträgers zu prüfen, sind verschiedene Verfahren bekannt. Bei einer solchen Prüfung wird im Wesentlichen geprüft, ob die Antennenspule einen Bruch aufweist und/oder ob zwei oder mehr Spulenwindungen der Antenne versehentlich kurzgeschlossen sind. Mängel dieser Art beeinträchtigen die Funktionsfähigkeit der Antennenspule erheblich bzw. zerstören diese vollständig.

Produktionsbegleitend erfolgt zumeist eine Prüfung der Antennenspule in Form einer Gleichstrom-Widerstandsmessung. Um eine solche ohmsche Messung korrekt und mit der erforderlichen Genauigkeit durchzuführen, ist in der Regel eine 4-Punkt-Messung erforderlich. Liegen die gemessenen Werte außerhalb eines vorgegebenen Intervalls, so kann dies auf einen Leiterbahnbruch oder einen Kurzschluss hindeuten. Mit einem solchen Verfahren kann allerdings lediglich der ohmsche Anteil der Antennenspule bestimmt werden. Eine frequenzabhängige Impedanz der Spule, bestehend aus der Induktivität der Spule, dem ohmschen Anteil sowie einem kapazitiven Anteil, welcher auch von einem Trägermaterial herrühren kann, kann auf diese Weise nicht bestimmt werden. Weiterhin ist dieses Prüfverfahren aufwendig, da eine Kontaktierung der Antennenspule erforderlich ist. Wird die Antennenspule mittels eines Druckprozesses hergestellt, beispielsweise mittels Silberleitpaste aufgedruckt, so kann es zudem vorkommen, dass die Paste bei der Widerstandsmessung noch nicht vollständig ausgehärtet ist und entsprechende Kontaktstifte, welche zur Kontaktierung verwendet werden, verunreinigt werden und anschließend gereinigt oder ausgetauscht werden müssen.

Alternativ können die Resonanzfrequenz der Antennenspule und deren Güte kontaktlos bestimmt werden. Dazu wird in der Regel ein Phasen- und Impedanz-Analysator verwendet. Ein solches, sehr aufwendiges Verfahren ist detailliert beispielsweise im "RFID-Handbuch" von Klaus Finkenzeller, 5. Auflage, Carl Hanser Verlag, München, 2008, in Kapitel 4.1.11.2, beschrieben.

Liegt die gemessene Resonanzfrequenz in einem vorgegebenen Bereich, so ist die Antennenspule funktionsfähig. Diese Art der Prüfung ist aussagekräftiger als eine rein ohmsche Messung, allerdings ungleich aufwendiger und am besten manuell durchzuführen. Die Zeitdauer einer solchen Prüfung liegt im Bereich von mehreren Sekunden. Daher wir diese Prüfung in der Regel nicht produktionsbegleitend durchgeführt, sondern lediglich an einigen Stichproben und für die Produktionsfreigabe.

Schließlich kann, wenn eine Antennenspule eines Transponders geprüft wird, welche also bereits mit dem entsprechenden integrierten Schaltkreis verbunden ist, die Ansprechfähigkeit des Transponders getestet werden. Eine solche Prüfung ist, selbst wenn sie positiv ausfällt, nicht immer aussagekräftig, da geringfügige Beschädigungen der Antennenspule, wie beispielsweise Haarrisse in einer Leiterbahn, nur eine Dämpfung und damit lediglich eine geringere Lesereichweite zur Folge haben. Dies beeinträchtigt generelle die Ansprechfähigkeit des Transponders im Test zumeist nicht. Allerdings sind solche Beschädigungen oftmals Grund für frühe Ausfälle des Datenträgers nach dessen Ausgabe an einen Nutzer und sollten daher bei der Prüfung bereits erkannt werden.

In DE10117249A1 und DE102008004772A1 wird eine Antennenspule mit einem Wechselfeld angeregt, welches verschiedene Frequenzen eines Frequenzbereiches durchläuft, um die maximale Dämpfung des Feldes im Frequenzbereich zu bestimmen.

Aufgabe der vorliegenden Erfindung ist es demnach, ein Verfahren und eine Vorrichtung zur schnellen, einfach durchzuführenden und kostengünstigen Prüfung einer Antennenspule hinsichtlich ihrer Funktionsfähigkeit vorzuschlagen. Wünschenswerterweise kann ein Ergebnis der Prüfung bei der weiteren Herstellung der Antennenspule nutzbringend verwendet werden. Diese Aufgabe wird durch ein Verfahren und eine Prüfvorrichtung sowie eine Vorrichtung zum Herstellen einer Antennenspule mit den Merkmalen der unabhängigen Ansprüche 1, 11 und 13 gelöst. Vorteilhafte Ausgestaltungen und Weiterbildungen der Erfindung sind in den abhängigen 2-10, 12, 14 und 15 angegeben.

Der Grundgedanke der vorliegenden Erfindung besteht darin, die zu prüfende Antennenspule zur Schwingung anzuregen und die durch die Anregung erzeugte freie, gedämpfte Schwingung der Antennenspule zu erfassen und auszuwerten, um eventuelle Mängel der Antennenspule zu erkennen. Demnach umfasst ein erfindungsgemäßes Verfahren zum Prüfen der Funktionsfähigkeit einer Antennenspule für einen kontaktlos kommunizierenden portablen Datenträger folgende die Schritte:

In einem ersten Schritt wird die Antennenspule zur Schwingung angeregt. Dies geschieht vorzugsweise induktiv durch ein gepulstes Magnetfeld, welches zum Beispiel in einfacher Weise durch einen einzelnen Gleichstrompuls erzeugt werden kann. Vorzugsweise besteht die Anregung aus einem einzelnen Magnetfeldpuls. Der Gleichstrompuls kann dabei vorteilhaft als Dirac-Stoß erzeugt werden. Es ist auch möglich, dass das Magnetfeld durch einen (Gleich-)Strompuls erzeugt wird, welcher lediglich - anders als ein Dirac-Stoß - eine steile Flanke aufweist. Bevorzugt erfolgt das Anregen der Antennenspule kontaktlos über eine Erregerspule, welche dazu mit einem entsprechenden Impulsgeber gekoppelt ist.

In einem zweiten Schritt des erfindungsgemäßen Verfahrens wird die freie, gedämpfte Schwingung der Antennenspule, welche in Antwort auf die Anregung erzeugt wird, erfasst. Dies geschieht vorzugsweise ebenfalls kontaktlos mittels einer Messantenne. Erregerspule und Messantenne werden dazu vorteilhaft in unmittelbarer Nähe der zu prüfenden Antennenspule angeordnet.

In einem dritten Schritt wird die erfasste freie, gedämpfte Schwingung der Antennenspule ausgewertet. Dies kann mittels einer geeigneten Auswertungseinrichtung geschehen, welche mit der Messantenne verbunden ist.

Eine erfindungsgemäße Prüfvorrichtung zum Prüfen der Funktionsfähigkeit der Antennenspule für einen kontaktlos kommunizierenden portablen Datenträger umfasst dazu einen Impulsgeber. Dieser ist eingerichtet, die Antennenspule über eine an den Impulsgeber angeschlossene Erregerspule kontaktlos zur Schwingung anzuregen. Weiter umfasst die Prüfvorrichtung eine Messantenne, welche eingerichtet ist, eine freie, gedämpfte Schwingung der Antennenspule kontaktlos zu erfassen. Eine Auswertungseinrichtung der Prüfvorrichtung schließlich, welche mit der Messantenne verbunden ist, ist eingerichtet, die von der Messantenne erfasste freie, gedämpfte Schwingung auszuwerten.

Die Auswertungseinrichtung kann dabei insbesondere einen Vergleich mit Referenzwerten einer intakten Antennenspule heranziehen. Zur Analyse der von der Messantenne beim Erfassen der freien, gedämpften Schwingung erfassten Signale kann in bekannter Weise beispielsweise ein digitaler Signalprozessor (DSP) oder ein Oszilloskop dienen.

Die in der beschriebenen Weise angeregte Antennenspule schwingt nach der Anregung unmittelbar mit einer freien, gedämpften Schwingung A(t) aus, welche mit der folgenden Formel beschrieben werden kann:

$$A(t) = A_0(t)\, e^{(-\delta t)} \cos \omega t.$$

A(t) kann dabei dem Strom I oder der Spannung U eines durch die Antennenspule gebildeten elektrischen Schwingkreises entsprechen. Demnach kann der Spannungsverlauf der Antennenspule unmittelbar nach der Anregung mit der folgenden Formel beschrieben werden:

$$U(t) = U_0(t)\, e^{(-\delta t)} \cos \omega t$$

Die Kreisfrequenz ω entspricht dabei der Eigenresonanzfrequenz der Antennenspule. Aus dem Abklingkoeffizienten δ kann die Güte der Antennenspule ermittelt werden. Je länger der Abklingvorgang dauert, desto höher ist die Güte des entsprechenden Schwingkreises. D.h. eine Auswertung der freien gedämpften Schwingung der Antennenspule, d. h. deren Ausschwingen unmittelbar nach der Anregung, erlaubt es, sowohl die Eigenresonanzfrequenz als auch die Güte der Antennenspule zu bestimmen.

Die Erfindung beruht nun auf dem Umstand, dass ein Defekt der zu prüfenden Antennenspule, wie beispielsweise eine Unterbrechung einer Leiterbahn oder ein Kurzschluss zwischen einzelnen Spulenwindungen der Antennenspule, dazu führt, dass sich ein bei einer beschriebenen Prüfung erkennbarer Signalverlauf des Ausschwingens signifikant von einem entsprechenden Signalverlauf des Ausschwingens einer intakten Antennenspule unterscheidet. Anhand der ausgewerteten freien, gedämpften Schwingung festgestellte Parameter einer fehlerhaften Spule, insbesondere deren Eigenresonanzfrequenz und deren Güte, unterscheiden sich deutlich von den entsprechenden Parametern einer intakten Antennenspule.

Ein Leiterbahnbruch beispielsweise zeigt sich in einem deutlich erkennbar veränderten Ausschwingverhalten, insbesondere einer veränderten, in der Regel erhöhten Eigenresonanzfrequenz. Im Falle eines Kurzschlusses von zwei oder mehr Spulenwindungen ist kaum mehr ein Ausschwingen zu beobachten.

Auf diese Weise kann beim Auswerten der freien, gedämpften Schwingung durch die Prüfvorrichtung nicht nur erkannt werden, ob die Antennenspule fehlerhaft ist oder nicht, sondern es kann im Falle eines Fehlers oder Mangels auch der Typ des Fehlers bzw. die Art des Mangels festgestellt werden.

Die Vorteile des erfindungsgemäßen Verfahrens sind offensichtlich und zahlreich. Die Prüfung der Antennenspule kann kontaktlos, mit sehr geringem Zeitaufwand und somit insbesondere während eines laufenden Produktionsprozesses durchgeführt werden. Insbesondere kann auch bereits eine gedruckte Antennenspule, welche noch nicht vollständig ausgehärtet ist, mit dem erfindungsgemäßen Verfahren geprüft werden. Die benötigte Prüfvorrichtung ist vergleichsweise einfach und kostengünstig bereitzustellen. Zudem erlaubt das Verfahren nicht nur, Fehler oder Mängel einer defekten Antennenspule zu erkennen, sondern auch verschiedene Fehlertypen zu unterscheiden. Das Verfahren erlaubt überdies bei unverändertem Aufbau sowohl ein Prüfen von unbestückten Antennenspulen, also solchen, welche noch nicht mit einem integrierten Schaltkreis verbunden sind, als auch von Antennenspulen mit angeschlossenem Schaltkreis, wie beispielsweise bereits fertiggestellten Transpondern oder kontaktlos kommunizierenden Chipkarten. Schließlich kann das Verfahren parallel für eine Mehrzahl von Antennen, welche beispielsweise nebeneinander auf einem Fertigungsbogen angeordnet sind, durchgeführt werden, ohne dass eine Abschirmung einzelner Antennen notwendig ist. Insgesamt können Antennenspulen somit schnell, auf einfache Weise und kostengünstig hinsichtlich ihrer Funktionsfähigkeit geprüft werden.

Vorzugsweise werden die Erregerspule und die Messantenne zum Prüfen der Antennenspule bzw. in der Prüfvorrichtung "orthogonal" zueinander angeordnet. In dem Fall, dass die Erregerspule und die Messantenne nicht orthogonal zueinander, sondern beispielsweise nebeneinander angeordnet sind, wird der Erregungsimpuls der Erregerspule auch von der Messantenne erfasst. Zudem überlagert dann das Abschwingverhalten der Erregerspule das zu messende Abschwingverhalten der Antennenspule.

Bei einer "orthogonalen" Anordnung der Erregerspule zu der Messantenne liegen diese derart zueinander, dass das Signal der Erregerspule von der Messantenne nicht wahrgenommen wird. Die Erregerspule ist dabei gegenüber der Messantenne räumlich so angeordnet, dass in der Messantenne im Wesentlichen kein Signal eingekoppelt wird. Ein Signal wird in eine Spule immer dann eingekoppelt, wenn das Ringintegral über den magnetischen Fluss Φ durch diese Spule größer als Null ist (vgl. oben zitiertes RFID-Handbuch, Kapitel 4.1.6 und 4.1.9.2). Das Integral über den magnetischen Fluss Φ ist genau dann Null, wenn sich magnetische Feldlinien unterschiedlicher Richtung und Feldstärke in der Messantenne über die Gesamtfläche gegenseitig aufheben, oder wenn der Winkel der Feldlinien zur Spulenachse genau 90° beträgt - daher der Begriff "orthogonale" Anordnung. Eine geeignete, nachstehend genauer beschriebene, so genannte koplanare orthogonale Anordnung der Erregerspule zur Messantenne kann beispielsweise derart erfolgen, dass die beiden Antennen in einer Ebene geeignet teilweise übereinander liegen.

Die Messantenne wird vorzugsweise so ausgelegt, dass die Güte der Messantenne möglichst klein ist und die Eingangskapazität eines gegebenenfalls angeschlossenen Verstärkers möglichst nicht wirksam werden kann, da die Messantenne selbst sonst eine starke Eigenschwingung in die Messung mit einbringen kann. Eine solche unerwünschte Eigenresonanz der Messantenne lässt sich beispielsweise mittels einer nachstehend genauer beschriebenen Kompensationsschaltung unterdrücken.

Abhängig von der Art eines durch die Prüfvorrichtung beim Prüfen der Antennenspule festgestellten Mangels kann es vorgesehen sein, dass zumindest ein Produktionsparameter zur Herstellung der Antennenspule neu bestimmt wird. Wenn die Antennenspule beispielsweise bei der Herstellung gedruckt wird, kann ein solcher Parameter beispielsweise die Dosierung der zu druckenden Leitpaste, die Breite einer zu druckenden Leiterbahn, die Anzahl der Spulenwindungen oder dergleichen betreffen. Ein neu bestimmter Produktionsparameter kann als Feedback in der laufenden Produktion helfen, dieselbe zu optimieren und die Herstellung einer größeren Zahl mangelhafter Antennenspulen zu verhindern.

Alternativ oder zusätzlich kann eine als mangelhaft erkannte Antennenspule in einem weiteren Schritt "repariert" oder optimiert werden. Dies kann durch nachträgliches Anordnen, insbesondere Drucken, fehlender Leiterbahnanteile, durch Überdrucken bestehender Leiterbahnanteile oder durch Entfernen nicht benötigter Anteile vorhandener Leiterbahnstrukturen geschehen, um die Antennenspule in dem Nachbearbeitungsschritt hinsichtlich vorgegebener physikalischer Parameter, wie beispielsweise deren ohmschen Widerstand, zu korrigieren oder anzupassen.

Dementsprechend umfasst eine erfindungsgemäße Vorrichtung zum Herstellen einer Antennenspule auf einem Trägermaterial für einen kontaktlos kommunizierenden portablen Datenträger eine Einrichtung zum Herstellen einer Antennenspule auf dem Trägermaterial, beispielsweise eine Druckvorrichtung. Weiterhin umfasst die Produktionsvorrichtung eine erfindungsgemäße Prüfvorrichtung zum vorstehend eingehend beschriebenen Prüfen der Antennenspule.

Wie erwähnt, ist die Auswertungseinrichtung der Prüfeinrichtung vorzugsweise eingerichtet, abhängig von der Art eines festgestellten Mangels der Antennenspule zumindest einen Produktionsparameter zur Herstellung weiterer Antennenspulen neu zu bestimmen.

Weiterhin ist die Produktionsvorrichtung vorzugsweise eingerichtet, eine nach der Prüfung der Antennenspule durch die Prüfvorrichtung als mangelhaft festgestellte Antennenspule in einem weiteren Schritt, wie vorstehend beschrieben, nachzubearbeiten.

Mit dem erfindungsgemäßen Verfahren können eine unbestückte Antennenspule, d.h. eine offene oder geschlossene Antennenspule ohne angeschlossenen integrierten Schaltkreis, oder ein Transponder in Form der Antennenspule mit angeschlossenem integrierten Schaltkreis geprüft werden.

Gemäß einer bevorzugten Ausführungsform des Prüfverfahrens wird die Funktionsfähigkeit an einer geschlossenen Antennenspule geprüft, welche noch nicht mit einem integrierten Schaltkreis verbunden ist. Die Antennenspule kann dabei bereits von Anfang an als geschlossene Antennenspule hergestellt worden sein oder aber zuerst als offene Antennenspule vorliegen, welche vor dem Prüfen durch Überbrücken der Enden der offenen Antennenspule zu einer geschlossen Antennenspule gemacht wird. Anschließend, d.h. nach dem Prüfen, wird gemäß dieser bevorzugten Ausführungsform eine Leiterbahn der Antennenspule zur Herstellung einer offenen Antennenspule unterbrochen, so dass die offenen Enden der Antennenspule mit Komponenten eines integrierten Schaltkreises, insbesondere einem Chip, verbunden werden können.

4

Diese bevorzugte Ausführungsform macht es auf einfache Weise möglich, Fehler, insbesondere Leitungsbrüche, in einer Antennenspule zu erkennen, welche sehr nahe an den Kontaktierungsenden der Spule auftreten. Herkömmliche kontaktlose Prüfverfahren, welche nicht an geschlossenen, sondern an offenen Antennenspulen durchgeführt werden, erkennen solche Fehler prinzipbedingt nicht oder kaum, da die physikalischen Eigenschaften eines Teils einer derart fehlerhaften Antennenspule, wenn der Teil nur groß genug ist, kaum von den physikalischen Eigenschaften einer intakten Spule zu unterscheiden sind, da die entsprechenden Leitungslängen nicht ausreichend voneinander unterscheiden.

Lag in der ursprünglichen Antennenspule ohne Chip ein Leiterbahnbruch vor, egal an welcher Stelle, d.h. auch nahe an einem der Kontaktierungsenden der Antennenspule, so ist die nun veränderte, d.h. durch Überbrückung der Kontaktierungsenden kurzgeschlossene Spule, immer noch offen und daher klar von einer intakten Spule, welche nun aufgrund der Überbrückung geschlossen sein sollte, zu unterscheiden. Das Ausschwingverhalten einer wie beschrieben geschlossenen Spule im Vergleich zu einer offenen Spule kann nicht verwechselt werden.

Gemäß einer Weiterbildung dieser bevorzugten Ausführungsform wird der Schritt des Prüfens der Antennenspule nach dem Unterbrechen der Spule und vor dem Anschließen des Chips wiederholt. Auf diese Weise können dann auch andere Mängel der Antennenspule, insbesondere ein Kurzschluss zwischen einzelnen Spulenwindungen, zuverlässig erkannt werden.

Die Erfindung wird nachfolgend mit Bezug auf die beiliegenden Zeichnungen beispielhaft beschrieben. Darin zeigen:

Figuren 1, 2     jeweils eine zu prüfende Antennenspule auf einer Trägerschicht;

Figur 3          den Verlauf einer freien, gedämpften Schwingung;

Figur 4          Komponenten einer ersten Ausführungsform einer erfindungsgemäßen Prüfvorrichtung;

Figur 5          eine bevorzugte Ausführungsform der Prüfvorrichtung aus Fig. 4;

Figur 6          eine bevorzugte Ausführungsform eines Anteils der Prüfvorrichtung aus Fig. 5 mit Bezug zu einer Messantenne;

Figur 7          einen Signalverlauf eines Erregerimpulses eines Impulsgebers;

Figur 8          einen Verlauf des Signals des Erregerimpulses mit an den Impulsgeber angeschlossener Erregerspule;

Figur 9          einen Signalverlauf einer freien, gedämpften Schwingung einer intakten Antennenspule, wenn diese mit einem Impuls gemäß Fig. 7 angeregt worden ist;

Figur 10         eine Vorgehensweise zur Ermittlung der Eigenresonanz der Antennenspule aus Fig. 9 anhand einer Auswertung der freien, gedämpften Schwingung;

Figur 11         einen Signalverlauf einer freien, gedämpften Schwingung einer intakten Antennenspule, wenn die Anregung durch einen in Fig. 12 gezeigten Impuls erfolgt ist;

Figur 12         einen alternativen Anregungsimpuls, welcher im Gegensatz zum Impuls aus Fig. 7 lediglich eine steile Flanke aufweist;

Figur 13         einen Signalverlauf einer freien gedämpften Schwingung einer Antennenspule mit einem Leiterbahnbruch;

Figur 14         einen Signalverlauf einer freien gedämpften Schwingung einer Antennenspule mit kurzgeschlossenen Spulenwindungen;

Figur 15         einen Signalverlauf einer freien, gedämpften Schwingung einer intakten Antennenspule, wenn Erregerspule und Messantenne nicht orthogonal zueinander angeordnet sind;

Figur 16         einen Signalverlauf einer freien, gedämpften Schwingung einer intakten Antennenspule, wenn Erregerspule und Messantenne orthogonal zueinander angeordnet sind;

Figur 17         einen Signalverlauf einer freien, gedämpften Schwingung einer Antennenspule mit Leiterbahnbruch, wenn Erregerspule und Messantenne orthogonal zueinander angeordnet sind;

Figuren 18, 19   jeweils einen Signalverlauf einer freien, gedämpften Schwingung einer Antennenspule mit einem Kurzschluss von zwei bzw. drei Spulenwindungen, wenn Erregerspule und Messantenne orthogonal zueinander angeordnet sind;

Figur 20          eine Vorgehensweise zur Auswertung einer erfassten freien, gedämpften Schwingung;

Figuren 21, 22          den Spannungsverlauf einer freien, gedämpften Schwingung zweier Antennenspulen mit abweichendem ohmschen Widerstand; und

Figuren 23, 24          Schritte beim Nacharbeiten einer Antennenspule anhängig von einer vorhergehenden Prüfung.

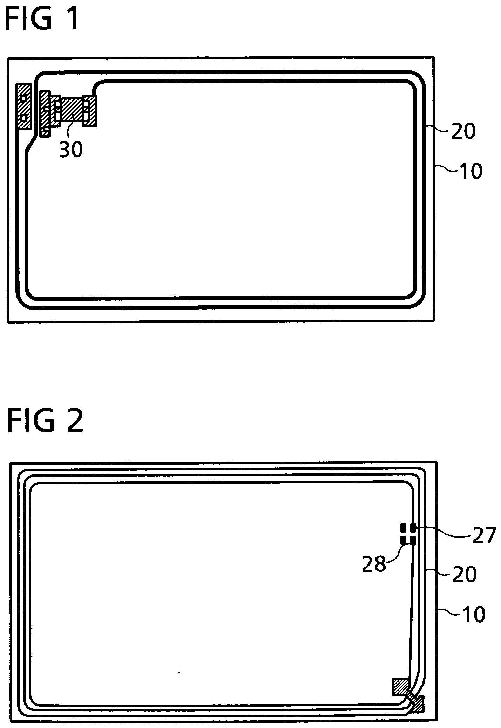

In den Figuren 1 und 2 sind zwei verschiedene Inlayschichten 10 eines portablen Datenträgers, im gezeigten Beispiel einer Chipkarte, mit darauf angeordneter Antennenspule 20 gezeigt. Die Antennenspule 20 kann dabei beidseitig aufgebracht sein, wobei zum Bilden eines Kreuzungspunktes dann eine Durchkontaktierung notwendig wird. Im Falle einer lediglich einseitig aufgebrachten Antennenspule, wie in Fig. 2 gezeigt, erfolgt eine Kreuzungsbildung mittels einer Brücke (in der Figur unten rechts). Auf der Trägerschicht 10 in Fig. 1 ist bereits ein integrierter Schaltkreis 30 mit der Antennenspule 20 verbunden worden, die Antennenspule 20 in Fig. 2 ist offen und noch unbestückt. Die Enden 27, 28 der offenen Antennenspule 20 sind als Kontaktstellen zur späteren Kontaktierung des Schaltkreises 30 vorgesehen.

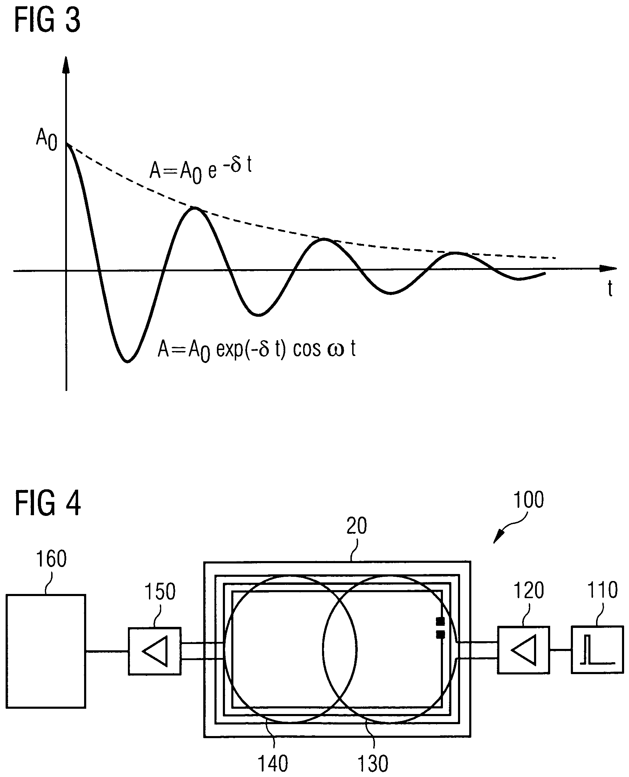

Fig. 3 zeigt den theoretischen Verlauf einer freien, gedämpften Schwingung A(t) im Verlauf der Zeit t. A(t) kann dabei dem Strom I oder der Spannung U entsprechen. Die Kreisfrequenz $\omega$ entspricht der Eigenresonanzfrequenz der entsprechenden Spule, aus dem Abklingkoeffizienten $\delta$ kann die Güte der Spule bestimmt werden.

Hier und im Folgenden wird aus Gründen der Einfachheit sowohl zur Bezeichnung einer unbestückten Antennenspule, d.h. einer Antennenspule ohne einen damit verbundenen Schaltkreis, als auch zur Bezeichnung eines Transponders, d.h. einer Antennenspule mit bereits verbundenem Schaltkreis, stets lediglich der Begriff "Spule" oder "Antennenspule" verwendet, soweit sich aus dem Zusammenhang nicht etwas anderes ergibt.

Fig. 4 zeigt schematisch den Aufbau einer Prüfvorrichtung 100 zum Prüfen einer Antennenspule 20. Die Vorrichtung 100 umfasst einen Impulsgeber 110 mit angeschlossenem Verstärker 120. Der Ausgang des Verstärkers 120 wird auf eine Erregerspule 130 gelegt, welche vorzugsweise lediglich eine Windung aufweist. Eine Messantenne 140 ist "orthogonal" zu der Erregerspule 130 angeordnet. An der Messantenne 140, welche vorzugsweise ebenso nur eine Spulenwindung besitzt, ist wiederum ein Verstärker 150 angeordnet, dessen Ausgang an eine Auswertungseinrichtung 160 angeschlossen ist.

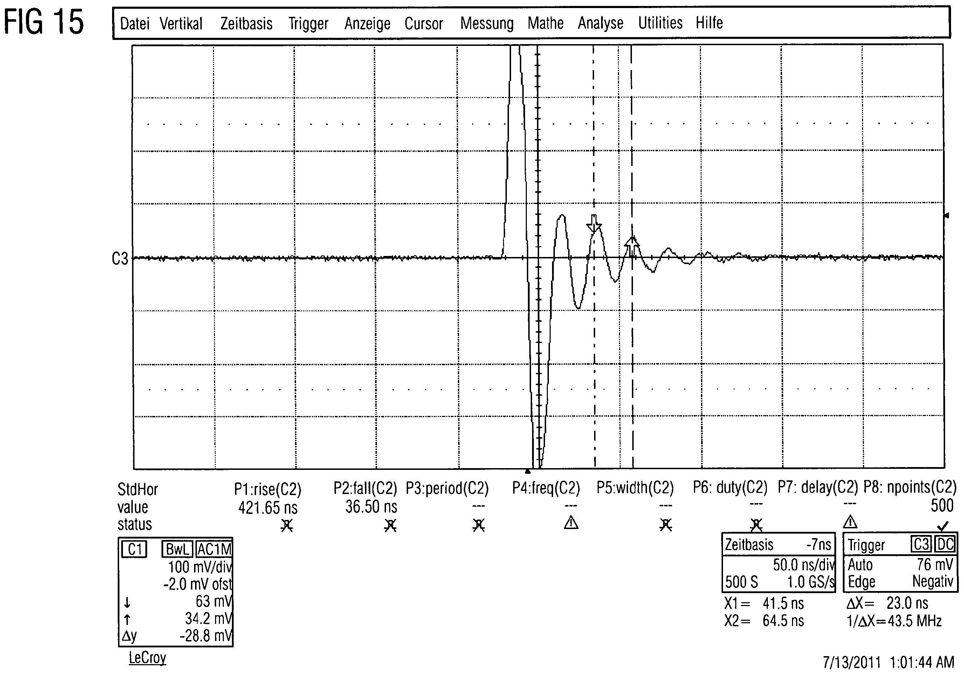

Im Rahmen dieser Erfindung wird der Begriff der "orthogonalen" Anordnung zweier Spulen zueinander, hier der Erregerspule 130 und der Messantenne 140, so verwendet, dass die Anordnung der Erregerspule 130 zu der Messantenne 140 räumlich derart erfolgt, dass in der Messantenne 140 möglichst kein Signal der Erregerspule 130 eingekoppelt wird. Wie vorstehend bereits erwähnt, ist dies genau dann der Fall, wenn das Ringintegral über den magnetischen Fluss $\Phi$ durch diese Spule größer als Null ist. Das Integral über den magnetischen Fluss $\Phi$ ist genau dann Null, wenn sich magnetische Feldlinien unterschiedlicher Richtung und Feldstärke in der Messantenne 140 über die Gesamtfläche gegenseitig aufheben, oder wenn der Winkel der Feldlinien zur Spulenachse genau 90° beträgt. Im gezeigten Beispiel sind die Erregerspule 130 und die Messantenne 140 koplanar "orthogonal" zueinander angeordnet, indem beide Spulen, wie dargestellt, teilweise übereinander angeordnet sind. Diese Anordnung kann weiter derart abgestimmt werden, dass das Integral über den magnetischen Fluss, wie gewünscht, Null ergibt. Dies folgt daraus, dass die von der Erregerspule 130 erzeugten magnetischen Feldlinien innerhalb und außerhalb der Erregerspule 130 in jeweils unterschiedliche Richtungen verlaufen. Der Grad der Überlappung der Erregerspule 130 und der Messantenne 140 wird nun so gewählt, dass sich diese Feldlinien in der Innenfläche der Messantenne 140 genau aufheben. Wie nachstehend mit Bezug auf Fig. 15 bis 19 beschrieben, erleichtert eine orthogonale Anordnung der Erregerspule 130 zur Messantenne 140 das Erfassen des Ausschwingens der zu prüfenden Antennenspule 20.

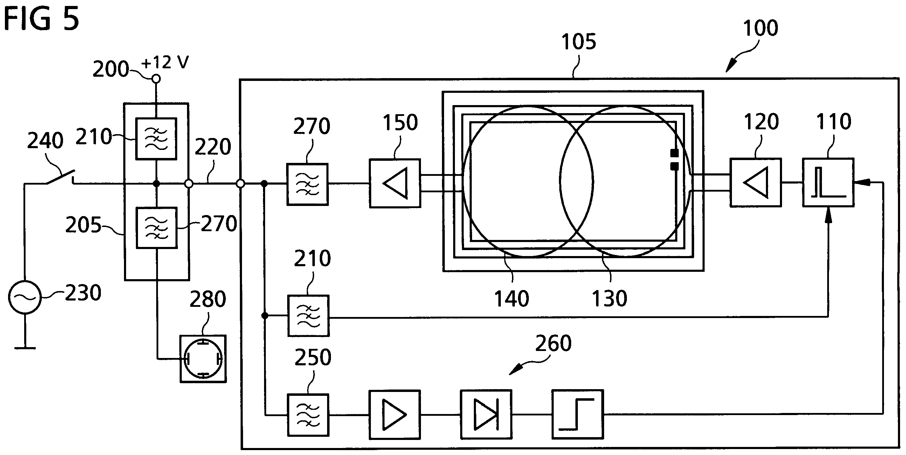

In Fig. 5 ist eine bevorzugte Ausführungsform 100' der Prüfvorrichtung 100 aus Fig. 4 gezeigt. Insbesondere wird dabei die Möglichkeit illustriert, eine Spannungsversorgung für eine Messschaltung, ein Triggersignal und das erfasste Messsignal über ein einziges Koaxialkabel 220 zwischen einer Messplatine 105 und einer Auswertungseinrichtung, beispielsweise einem Oszilloskop 280, zu übertragen. Über eine Adapterplatine 205 werden die Versorgungsspannung und ein Triggersignal eingespeist sowie ein Messsignal ausgekoppelt. Es bilden sich dabei folgende Übertragungskanäle aus, welche über das Koaxialkabel 220 geführt werden:
Ein erster Übertragungskanal verläuft von einem Netzteil 200 über einen Tiefpass 210, das Koaxialkabel 220, und einen weiteren Tiefpass 210 zur Spannungsversorgung der Messplatine 105.

Ein zweiter Übertragungskanal startet bei einem Signalgenerator 230 für einen Signalton zum Triggern eines Impulses, im gezeigten Beispiel eines Dirac-Impulses, verläuft über einen Auslöser 240 in Form eines Schalters, gegebenenfalls (nicht gezeigt) über einen Bandpass, das Koaxialkabel 220, einen weiteren Bandpass 250, und eine Auswertungsschaltung 260 der Messplatine 105 zum Impulsgeber 110.

Ein dritter Übertragungskanal schließlich verläuft von der Messantenne 140 über den Messverstärker 150 auf der Messplatine 105, einen Hochpass 270, das Koaxialkabel 220 und einen weiteren Hochpass 270 zum Oszilloskop 280.

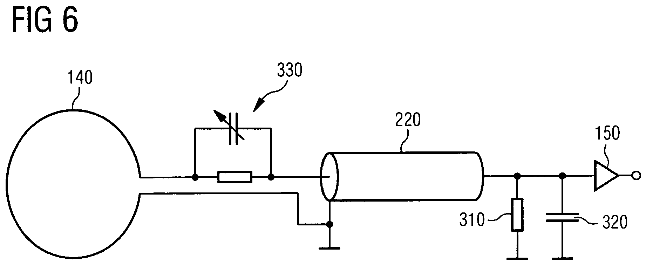

Fig. 6 zeigt ein bevorzugtes Design der Messantenne 140. Dieses ist so ausgelegt, dass die Messantenne 140 eine möglichst geringe Güte aufweist und dass die Eingangskapazität des über das Koaxialkabel 220 angeschlossenen Verstärkers 150 möglichst nicht wirksam werden kann, da die Messantenne 140 ansonsten eine starke Eigenschwingung in die Messung einbringen würde. Dies würde die Messung, d.h. das Erfassen der freien gedämpften Schwingung der zu prüfenden Antennenspule 20, beeinträchtigen. Insbesondere müsste die Eigenschwingung stets herausgerechnet werden. In der Figur sind Eingangskapazität 320 und Eingangswiderstand 320 des Verstärkers 150 gezeigt. Die Eigenresonanz der Messantenne 140 lässt sich mittels einer Kompensationsschaltung 330 unterdrücken. Diese besteht aus einer Parallelschaltung einer Kapazität und eines Widerstandes, wobei diese Größen typischerweise im Bereich vom ca. 1 bis 50 pF bzw. 1 bis 10 MOhm liegen. Die Kompensationsschaltung 330 liegt dabei in Reihe zu der Messantenne 140. Durch den hohen Reihenwiderstand geht die Güte der Messantenne 140 praktisch gegen Null. Dadurch wird die Eigenresonanz nicht mehr wirksam. Zur Berechnung dieser Kompensationsschaltung 330 können beispielsweise die für die Berechnung der Kompensation für Oszilloskop-Tastköpfe bekannten Formeln verwendet werden

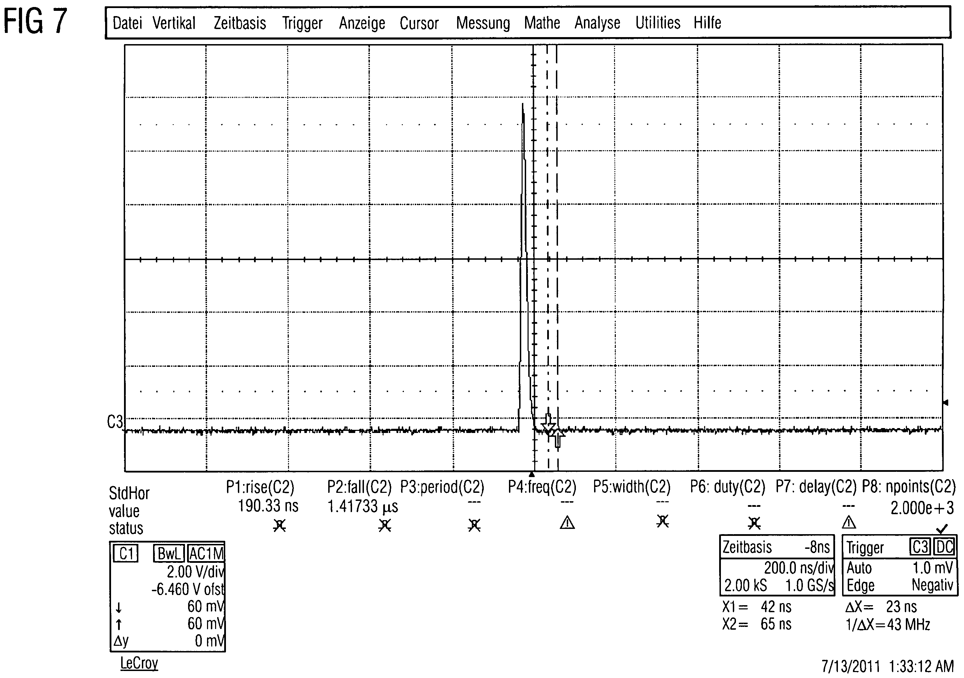

Gemäß einer ersten Ausführungsform des Prüfverfahrens wird die Antennenspule durch einen Dirac-Impuls angeregt. Dazu wird der Impulsgeber 110 so eingestellt, dass er eine maximale Amplitude in kürzest möglicher Zeit erreicht. Es kann dabei beispielsweise eine Amplitude von 12 V mit einer Breite von nur 29 ns erreicht werden. In Fig. 7 ist ein entsprechender Signalverlauf angegeben.

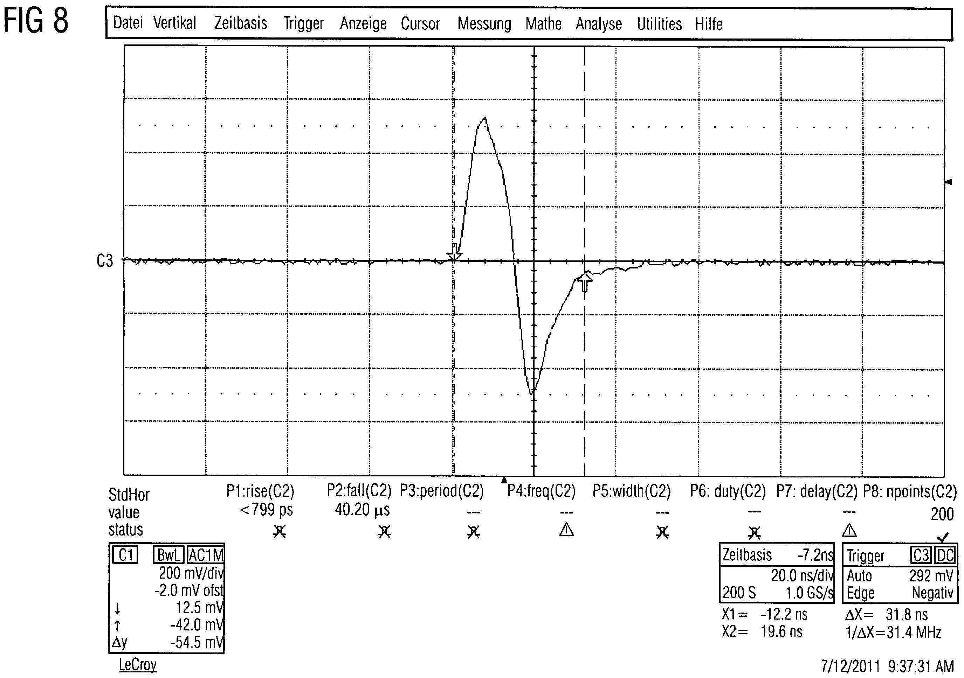

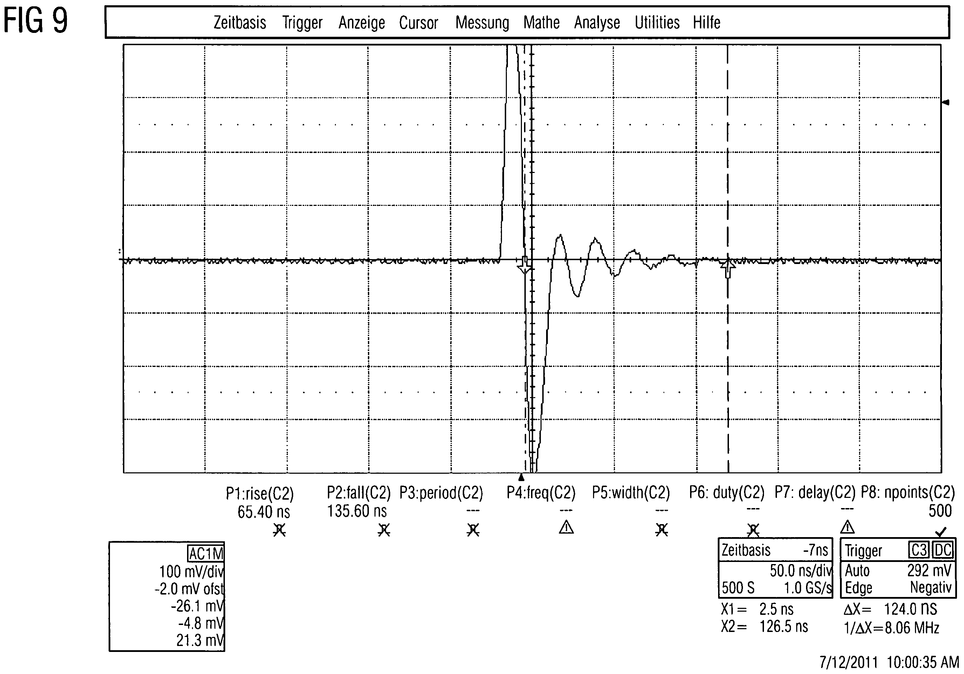

Wird nun der Impulsgeber 110 an die Erregerspule 130 angeschlossen, so ergibt sich - ohne Anordnung der Antennenspule 20 - durch die im dadurch entstehenden magnetischen Feld entstehende Energie ein von der Messantenne 140 erfasster Signalverlauf mit nachfolgender Ausschwingzeit, wie er in Fig. 8 illustriert ist. Die Messantenne 140 ist hier und mit Bezug zu den folgenden Figuren 9 bis 14 nicht orthogonal zur Erregerspule 140 angeordnet. Die Vorteile einer orthogonalen Anordnung dieser Spulen werden, wie bereits erwähnt, mit Bezug auf die Figuren 15 bis 19 beschrieben.

Wird nun eine zu prüfende Antennenspule 20 direkt unter der Erregerspule 130 angeordnet, so wird die Antennenspule durch den positiven Dirac-Impuls des Impulsgebers 110 zu einer freien, gedämpften Schwingung angeregt. Aus dem resultierenden typischen Ausschwingen der Antennenspule 20 können die Eigenresonanzfrequenz der Antennenspule 20 sowie deren Güte ermittelt werden. Weist die Antennenspule 20 einen Fertigungsfehler auf, beispielsweise einen Leiterbahnbruch oder einen Kurzschluss zwischen einzelnen Spulenwindungen, so führt dies, wie nachfolgend illustriert, zu einem signifikant abweichenden Signalverlauf der "Nachschwingung", d.h. der entsprechenden freien, gedämpften Schwingung der beschädigten Antennenspule. Insbesondere Eigenresonanzfrequenz und/oder Güte einer solchen Spule unterscheiden sich deutlich erkennbar von den entsprechenden Werten einer intakten Antennenspule.

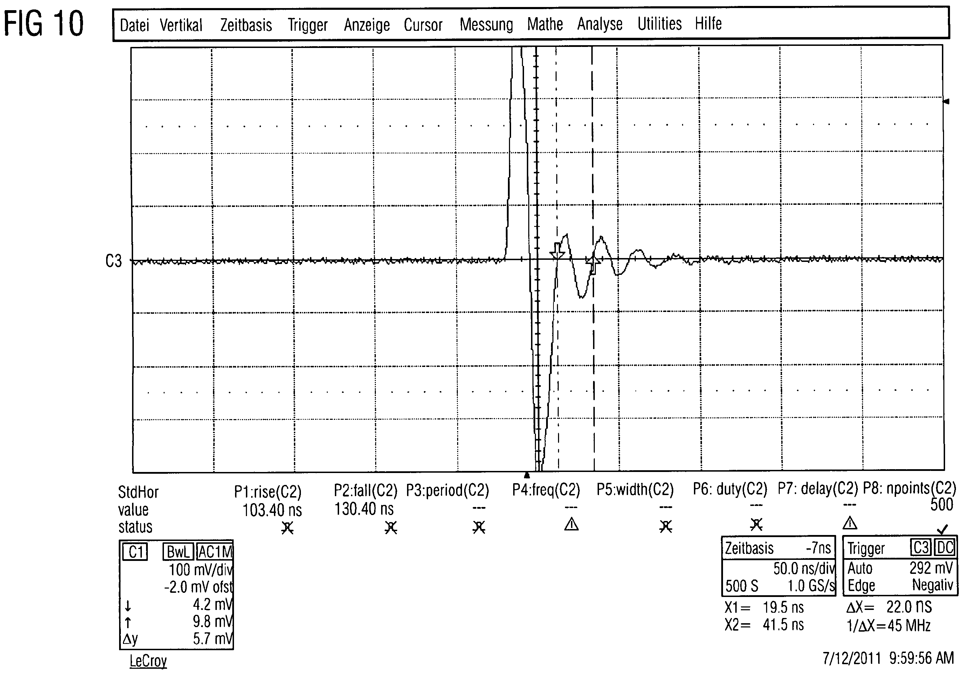

In Fig. 9 ist der Signalverlauf einer freien, gedämpften Schwingung einer intakten Antennenspule 20 dargestellt. In Fig. 10 ist mittels der Pfeile in der Figur angedeutet, wie anhand des erfassten Signalverlaufs die Eigenresonanz der geprüften Spule bestimmt werden kann. Die den Messergebnissen in Fig. 10 zu Grunde liegende offene Antennenspule ohne Chip besitzt beispielsweise eine Eigenresonanzfrequenz von ca. 45 MHz.

Ein Transponder, d.h. eine Antennenspule mit angeschlossenem integrierten Schaltkreis, besitzt in der Regel eine Eigenresonanzfrequenz in der Größenordnung der Sendefrequenz eines zugehörigen Lesegeräts. Kontaktlose Chipkarten gemäß ISO/IEC 14443 sind bei einer vorgegebenen Lesefrequenz von 13,56 MHz meist im Bereich von 15 bis 17 MHz abgestimmt.

Eine Antennenspule ohne angeschlossenen integrierten Schaltkreis auf einem entsprechenden Trägermaterial bildet zusammen mit den zwischen den Windungen auftretenden parasitären Kapazitäten ebenfalls einen Schwingkreis, zumeist mit einer Eigenresonanzfrequenz im Bereich von 30 bis 50 MHz, abhängig von der Dielektrizitätskonstante des Trägermaterials und der Windungsanzahl.

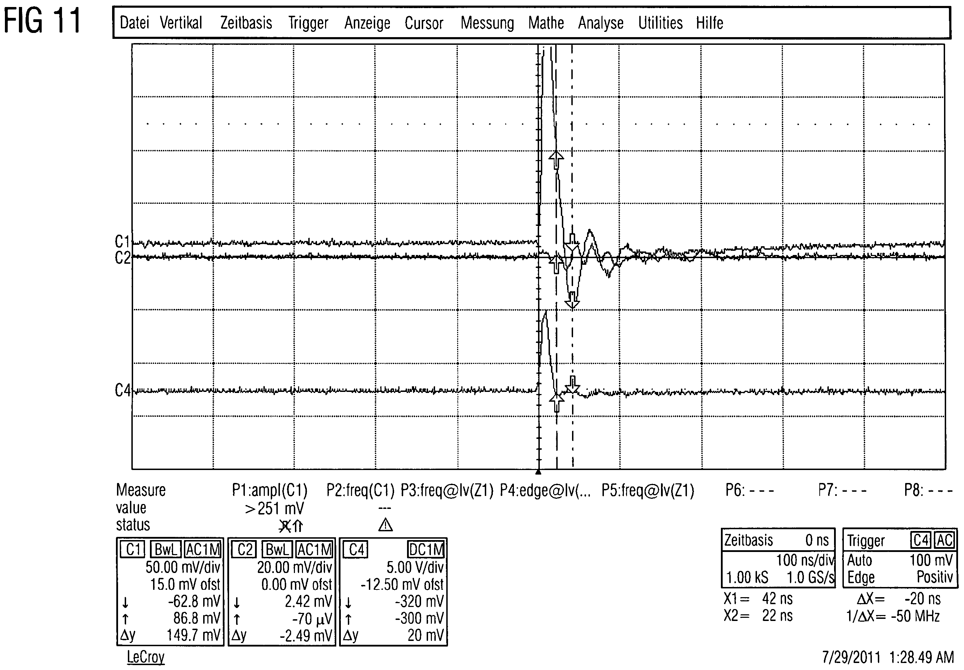

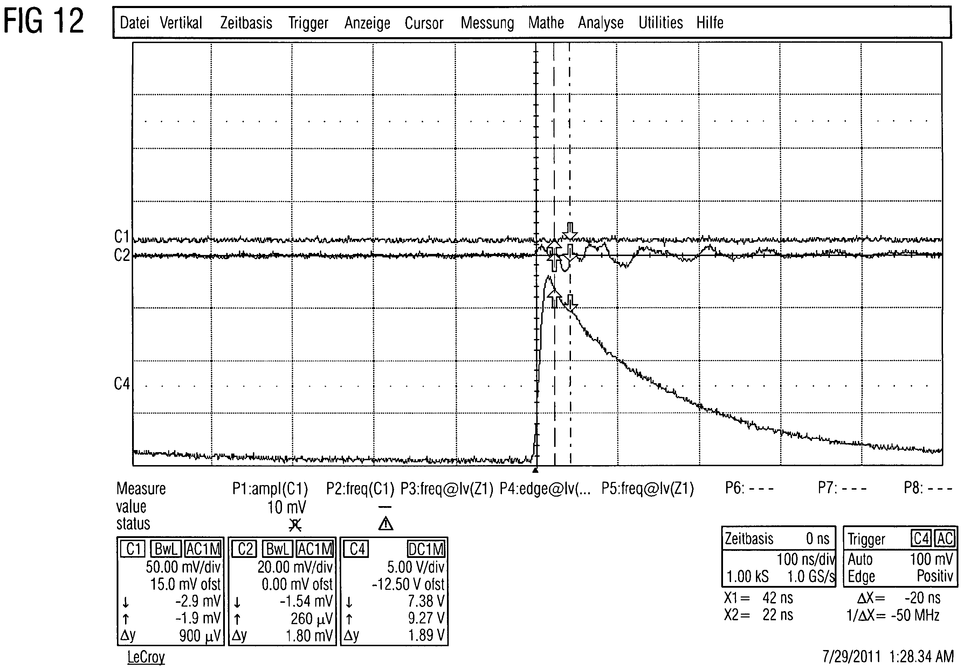

Fig. 11 und 12 zeigen, welcher Signalverlauf sich für eine intakte Antennenspule 20 ergibt (Fig. 11), wenn statt eines Dirac-Impulses (wie in Fig. 7 dargestellt) zur Anregung der Antennenspule 20 ein Impuls verwendet wird, der lediglich eine steile Flanke aufweist (Fig. 12). Die zweite Flanke des Impulses ist in diesem Beispiel exponentiell abfallend. Grundsätzlich kann jede der beiden Flanken als die steile Flanke vorgesehen werden. Ein solcher Impuls bringt gegenüber einem Dirac-Impuls den Vorteil, dass beim Erreger lediglich eine steile Flanke benötigt wird, und dass damit in der zu prüfenden Antennenspule 20 auch lediglich ein starker Puls in lediglich einer Polarität erzeugt wird (vgl. Fig. 11). Ein solches Erregersignal kann sich somit als vorteilhaft erweisen, da nur Energie in einer Richtung (Polarität) in die zu prüfende Antennenspule eingebracht wird.

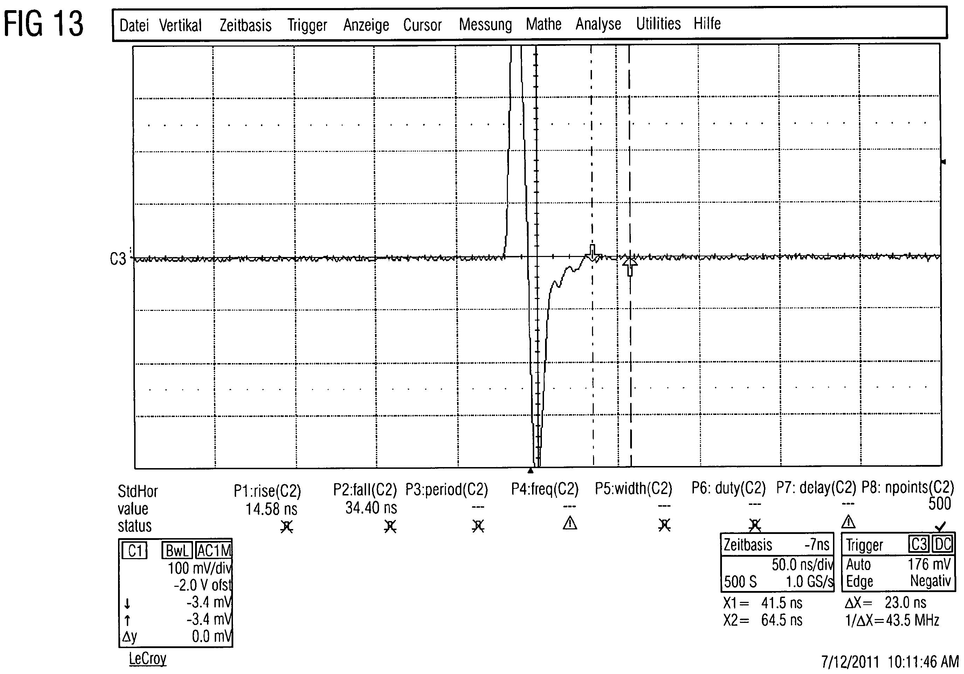

Die Signalverläufe, welche mit Bezug auf die Fig. 13 bis 19 nachfolgend beschrieben werden, basieren, um Vergleichbarkeit zu den Signalverläufen der Fig. 7 bis 10 zu gewährleisten, auf einer Anregung durch einen Dirac-Impuls.

In Fig. 13 ist der Signalverlauf einer freien, gedämpften Schwingung einer Antennenspule 20 gezeigt, welche einen Leiterbahnbruch aufweist. Die Eigenresonanzfrequenz der Spule, d.h. der unterbrochenen Spulenteilstücke, ist noch erkennbar. Diese sind im Vergleich zur intakten Spule (vgl. Fig. 9, Fig. 10) deutlich erhöht.

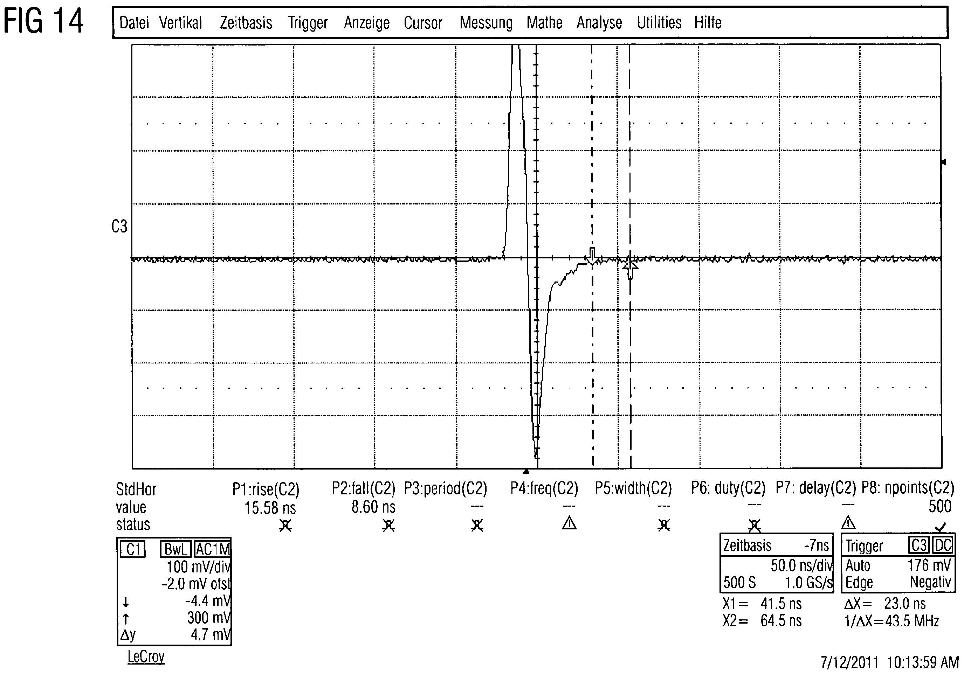

Wie mit Bezug auf Fig. 14 zu sehen, ist im Falle eines Kurzschlusses von Spulenwindungen der Antennenspule 20 kaum mehr ein Ausschwingen der Spule zu erkennen.

D.h. die beiden hauptsächlich auftretenden Fehler einer zu prüfenden Antennenspule 20, ein Leiterbahnbruch oder ein Kurzschluss zwischen Spulenwindungen, können durch Erfassen und Auswerten einer in Folge der Anregung der Spule 20 durch einen Impuls auftretenden freien, gedämpften Schwingung der Antennenspule zuverlässig erkannt werden.

Wie bereits erwähnt und in Fig. 15 nochmals illustriert, wird in dem Fall, dass die Erregerspule 130 und die Messantenne 140 nicht orthogonal zueinander angeordnet sind, der in die Erregerspule 130 gegebene Dirac-Impuls auch von der Messantenne 140 erfasst. Zudem überlagert das Abschwingverhalten der Erregerspule 130 das eigentlich von der Messantenne 140 zu erfassende Abschwingverhalten der Antennenspule 20.

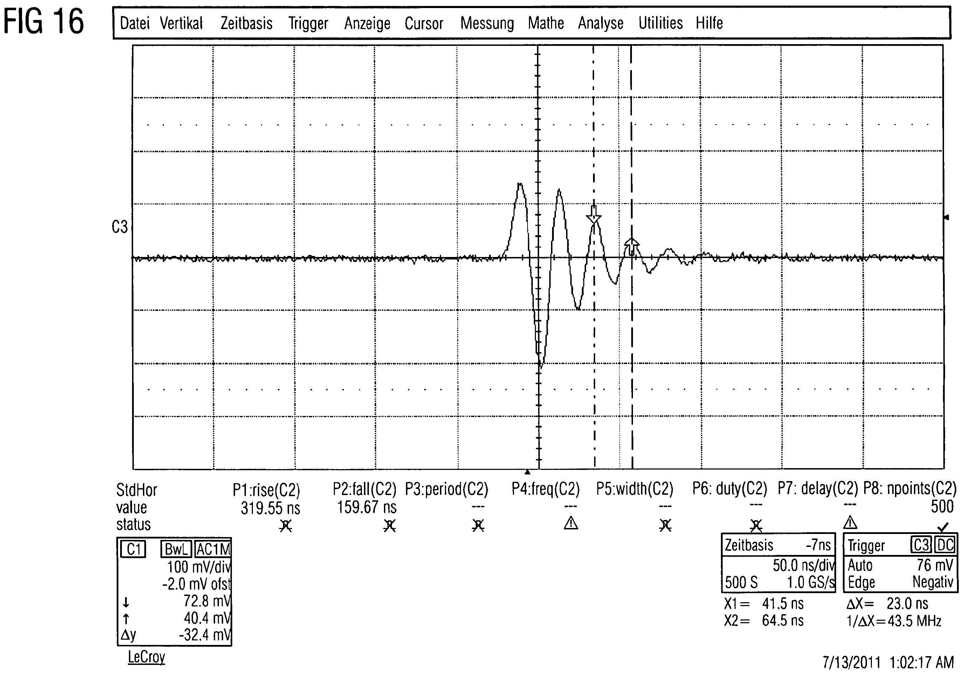

Werden die Erregerspule 130 und die Messantenne 140 in vorstehend mit Bezug auf Fig. 4 beschriebener Weise orthogonal zu einander angeordnet, so wird das Signal der Erregerspule 130 von der Messantenne 140 praktisch nicht "gesehen". In Fig. 16 ist die gleiche Messung wie in Fig. 15 gezeigt, allerdings mit orthogonal zu der Erregerspule 130 angeordneter Messantenne 140. Der Dirac-Impuls ist hier als ein den Signalverlauf überlagerndes Signal nicht mehr zu erkennen.

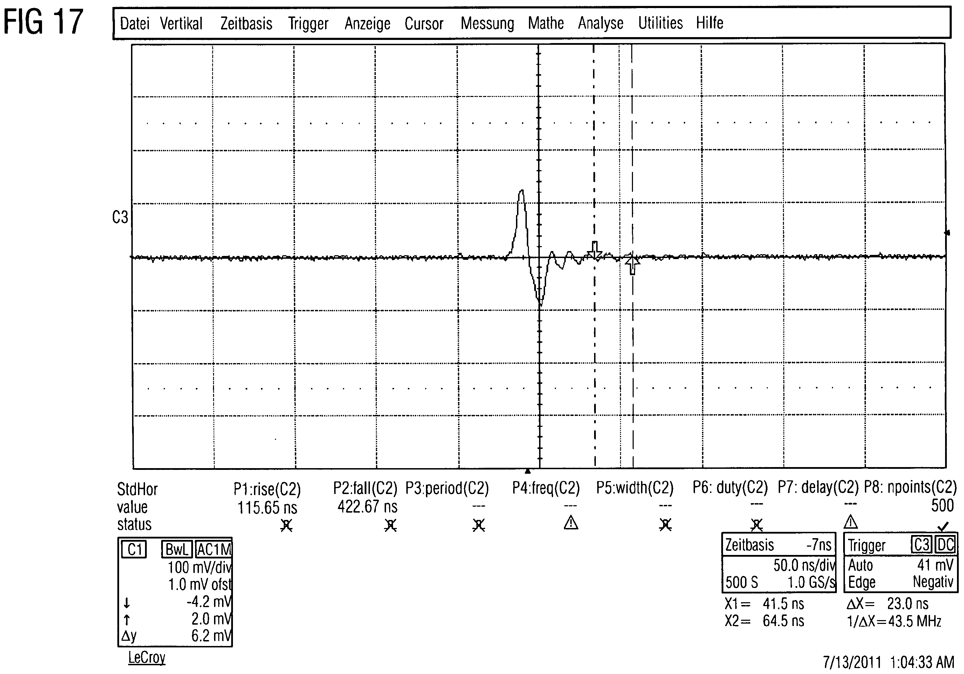

Die Erfassung einer freien gedämpften Schwingung einer Antennenspule 20 mit einem Leiterbahnbruch liefert mit einer solchen Messanordnung einen Signalverlauf, wie er in Fig. 17 zu sehen ist.

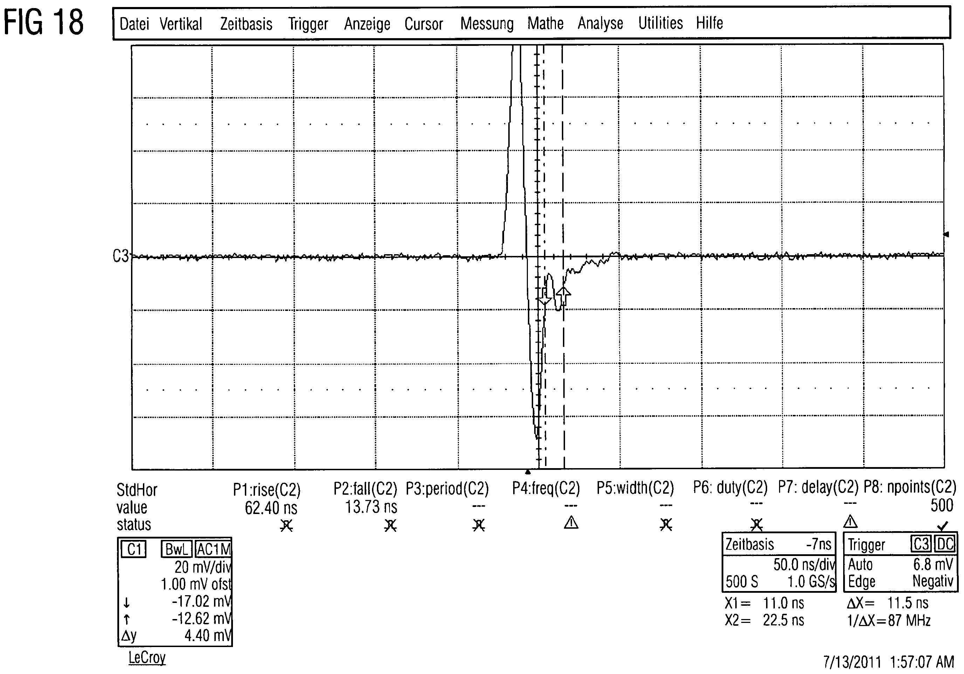

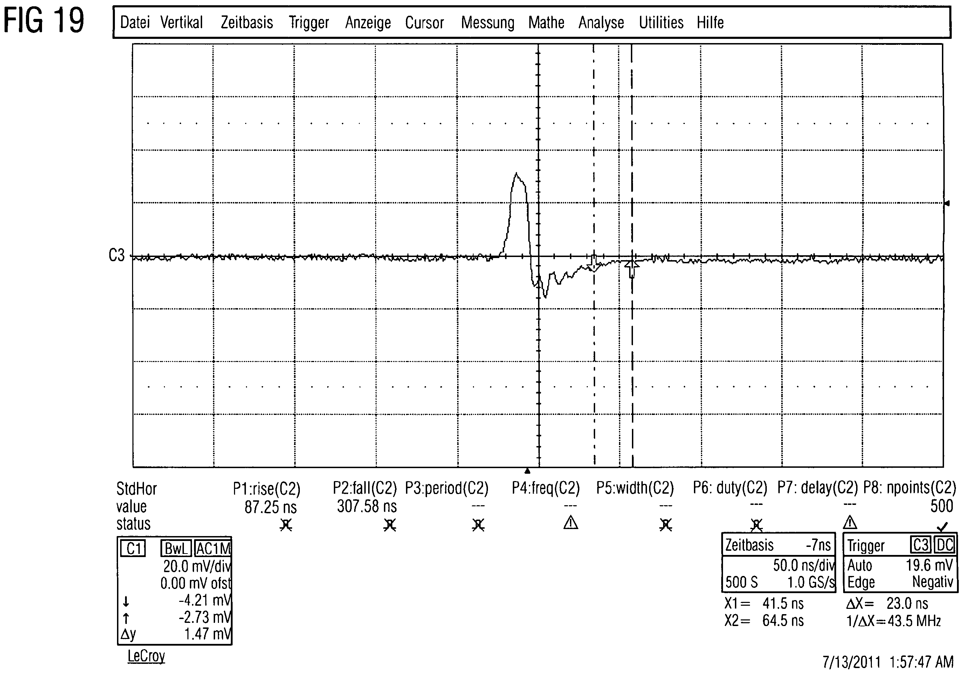

Wie mit Bezug auf die Figuren 18 und 19 zu sehen ist, kann mit dieser Messanordnung auch ein Leiterbahnschluss über zwei Windungen (Fig. 18) von einem Leiterbahnschluss über drei Windungen (Fig. 19) unterschieden werden. Die gemessene Eigenresonanz der Spule mit zwei kurzgeschlossenen Windungen beträgt 87 MHz. Bei drei kurzgeschlossenen Windungen wird eine Eigenresonanz von sogar 125 MHz bestimmt. Die Erhöhung der Resonanzfrequenz ist dabei auf eine signifikante Verringerung der Spuleninduktivität durch die kurzgeschlossene Leiterschleife zurückzuführen, welche mit der verbleibenden Antennenspule nach wie vor induktiv verkoppelt ist.

Die Auswertung der mittels der Messantenne 140 erfassten Signale kann auf verschiedene Weise durchgeführt werden. Gemäß einer ersten Ausführungsform kann ein digitaler Signalprozessor (DSP) zur Auswertung dienen. Dabei werden Datensätze von intakten Antennenspulen zur Verifikation erfasster Daten verwendet. Der DSP wandelt dabei das gemessene Signal mittels eines A/D-Wandlers um und überprüft das gewandelte Signal anhand gespeicherter Referenzwerte. Alternativ oder zusätzlich kann der DSP auch die Eigenresonanz der Antennenspule ermitteln sowie den Spannungspegel des Ausschwingens überprüfen.

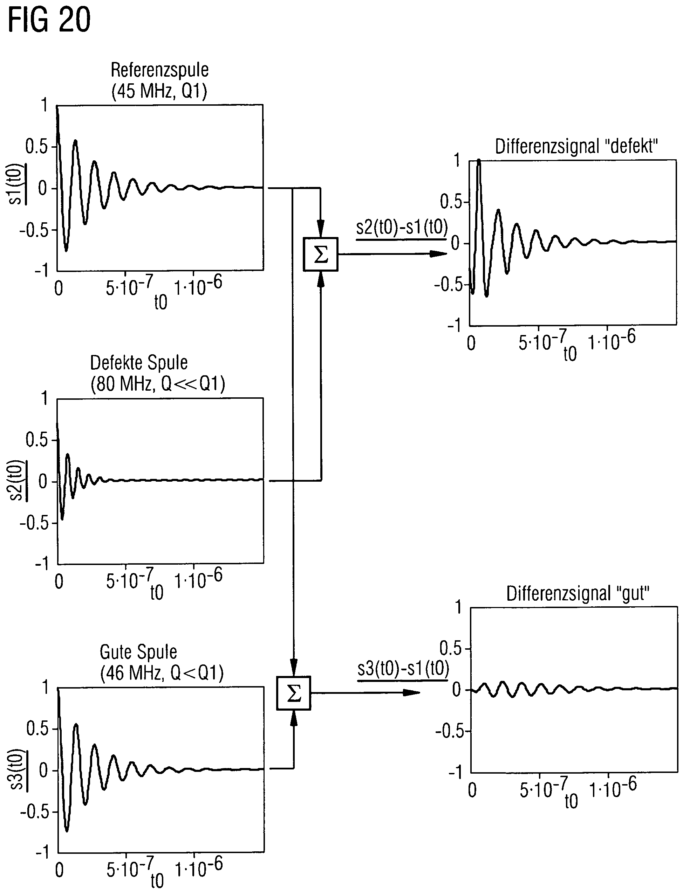

Gemäß einer zweiten Ausführungsform anhand einer Referenzspule wird eine parallele Referenzmessung mit einer als intakt bekannten Antennenspule durchgeführt. Bei diesem Auswertungsverfahren muss also lediglich der Abstand, das Delta, zwischen dem für die zu prüfenden Antennenspule erfassten Signal und dem Signal der Referenzspule bestimmt werden, wie dies in Fig. 20 illustriert ist. Weicht dieses Delta zu weit von vorgegebenen Grenzwerten ab, so wird die geprüfte Antennenspule als fehlerhaft eingestuft. Eine beschriebene Delta-Bildung zweier Signale kann bereits mit einem einfachen Differenzverstärker (Komparatorschaltung) und nachfolgenden Peak-Detektoren erfolgen.

Gemäß einer dritten Ausführungsform kann ein Oszilloskop mit Hilfe gespeicherter Grenzwerte die aktuell erfassten Daten auswerten. Mit dem von dem Oszilloskop in der Regel zur Verfügung gestellten mathematischen Funktionen kann auf einfache Weise automatisch die Eigenresonanz und die Güte der geprüften Antennenspule bestimmt werden.

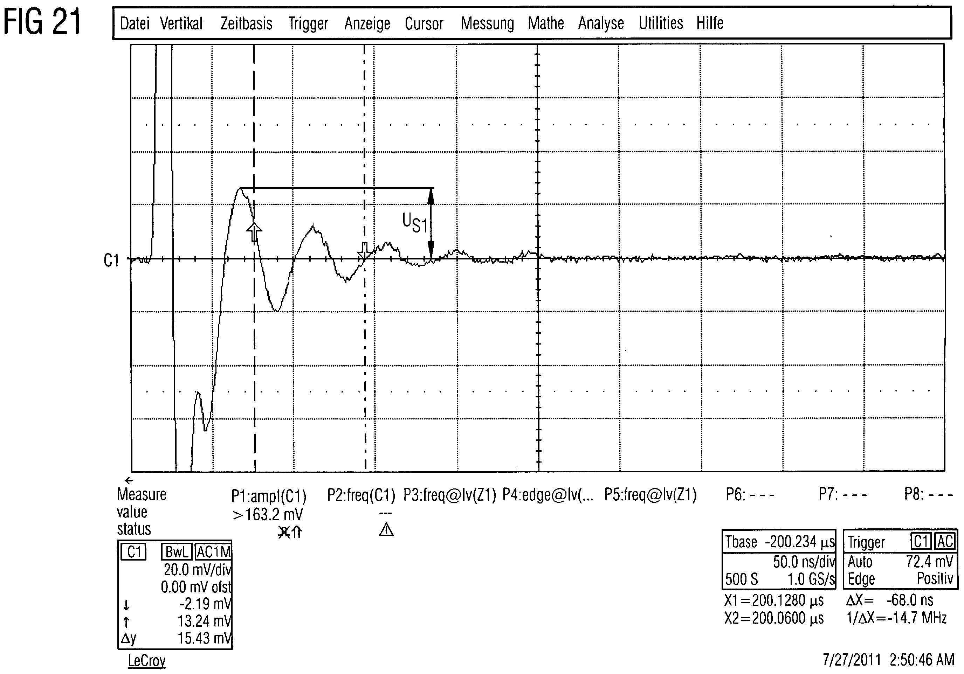

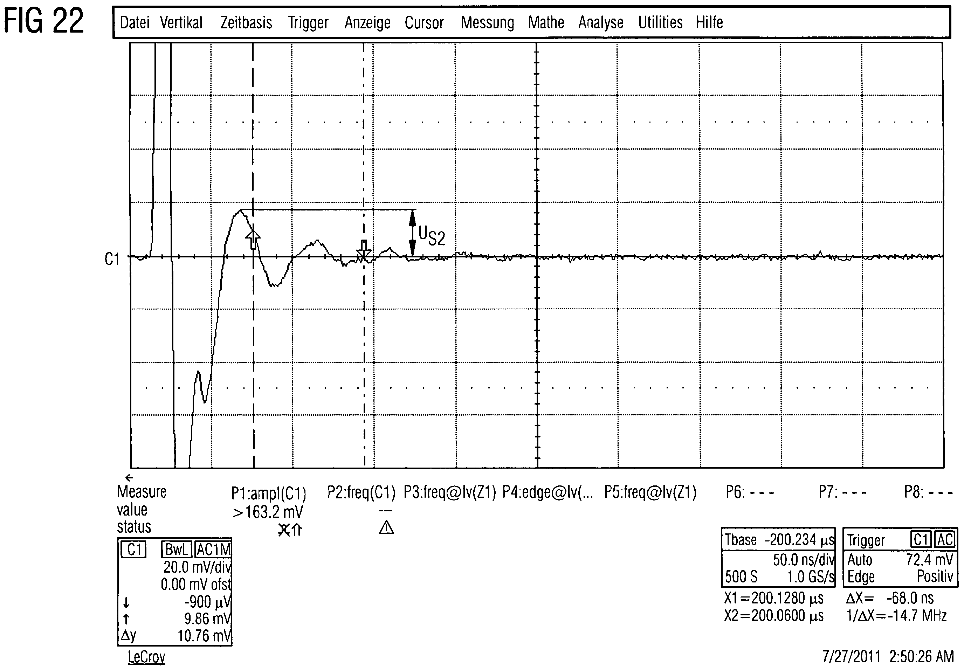

Wie in den Figuren 21 und 22 dargestellt, gibt es einen eindeutigen Zusammenhang zwischen dem Spannungsverlauf, genauer der erfassten Spitzenspannung U der Impulsantwort einer Antennenspule S, und deren ohmschen Widerstand R. Fig. 21 zeigt eine Messung an einer Antennenspule S1 mit einem Spulenwiderstand $R_{S1}$ von 89 Ohm. Der Spulenwiderstand $R_{S2}$ der Antennenspule S2 zu der Messung aus Fig. 22 beträgt 108 Ohm. Genauer zeigt sich, innerhalb der üblichen Toleranzen, ein linearer Zusammenhang zwischen diesen beiden Größen, d.h. wenn mit $U_{S1}$ und $U_{S2}$ die entsprechenden, für die Spulen S1 und S2 erfassten Spitzenspannungen bezeichnet werden und mit $R_{S1}$ und $R_{S2}$ die ohmschen Widerstände der Spulen S1 und S2, so gilt: $U_{S1}/ U_{S2} = R_{S2}/ R_{S1}$. Damit wird es möglich, wenn beispielsweise die Spule S1 als bekannte Referenzspule herangezogen wird, anhand des Spannungsverhältnisses, welches aus $U_{S1}$ und der Spitzenspannung $U_{S2}$ für eine zu prüfende Spule S2 bestimmt wird, den ohmsche Widerstand $R_{S2}$ der Spule S2 zu errechnen. Diese Beziehung ist durch kontaktierte, ohmsche Messung verifiziert worden.

Aufgrund der Tatsache, dass das erfindungsgemäße Prüfverfahren, wie zuvor mit Bezug auf die Figuren 13 und 14 sowie 17 bis 19 erläutert, nicht nur in der Lage ist, zwischen intakten Antennenspulen und solchen, die einen Fertigungsfehler aufweisen, zu unterscheiden, sondern auch verschiedene Fehlertypen zu erkennen, kann das Ergebnis des Prüfverfahrens in dem Herstellungsprozess der Antennenspule effektiv genutzt werden.

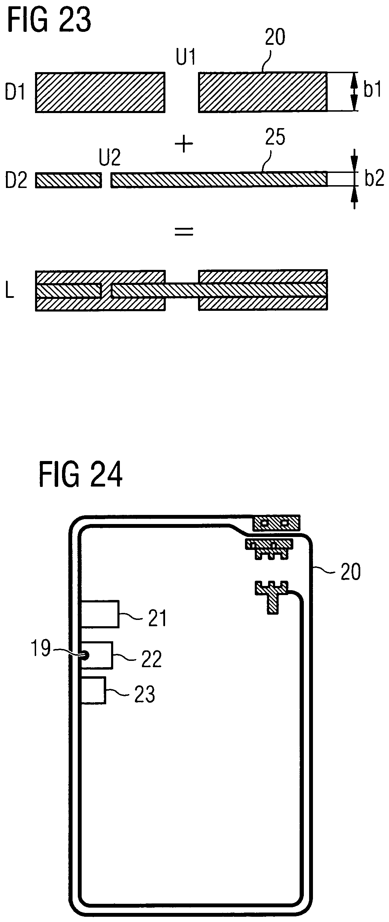

Zum einen können als defekt erkannte Antennenspulen aussortiert werden. Zum zweiten ist es aber auch möglich, anhand der Ergebnisse des Prüfverfahrens sowohl Produktionsparameter der vorhergehenden Antennenherstellung im Wege einer Rückkopplung anzupassen, als auch eine differenzierte Nacharbeit einzelner Antennenspule durchzuführen, wie dies nachfolgend mit Bezug auf die Figuren 23 und 24 exemplarisch beschrieben wird.

Es war beispielsweise bisher üblich, um Unterbrechungen gedruckter Antennenspulen zu vermeiden, die Leitenbahnen der Spulen zweimal zu drucken. Auf diese Weise kann mit hoher Wahrscheinlichkeit der Fall ausgeschlossen werden, dass bei jedem der beiden Druckvorgänge an derselben Stelle der Antennenspule eine unerwünschte Unterbrechung verbleibt - wodurch die Leiterbahn insgesamt unterbrochen wäre. Die generelle Vorgehensweise ist schematisch in Fig. 23 illustriert. Fig. 23 zeigt einen kleinen Ausschnitt der Leiterbahn in Aufsicht. In einem ersten Druckdurchgang D1 wird die Leiterbahn mit einer Breite b1 gedruckt. Wie dargestellt, kann es vorkommen, dass dabei eine unerwünschte Unterbrechung U1 entsteht. Um diese zu schließen, wird ein zweiter Druckvorgang D2 durchgeführt. Dabei wird in der Regel eine Leiterbahn geringerer Breite b2 auf die bereits vorliegende Leiterbahn gedruckt. Die sich dabei ergebende Gesamtstruktur ist in Fig. 23, in der unteren Zeile, mit L bezeichnet dargestellt. Auch beim zweiten Druckvorgang können, wie dargestellt, unerwünschte Unterbrechungen U2 entstehen. Die Wahrscheinlichkeit, dass diese allerdings innerhalb bereits bestehender Unterbrechungen U1 liegen, ist sehr gering. Auf diese Weise kann im Wesentlichen sichergestellt werden, dass eine derart zweifach gedruckte Antennenspule keinen Leiterbahnbruch aufweist.

Dieses Vorgehen ist sehr aufwendig, sowohl zeitlich als auch hinsichtlich des Materialverbrauchs.

Das erfindungsgemäße Prüfverfahren liefert nun Ergebnisse, die es erlauben, den beschriebenen Produktionsprozess zu optimieren. Die Anzahl als defekt erkannter Antennenspulen kann dahingehend ausgewertet werden, dass die Anzahl festgestellter Leiterbahnbrüche und die Anzahl erkannter Windungskurzschlüsse einander gegenübergestellt wird. Eine hohe Anzahl von Leiterbahnbrüchen kann darauf hindeuten, dass beispielsweise die Menge der zum Drucken der Leiterbahn verwendeten Leitpaste erhöht werden sollte. Eine große Anzahl von Kurzschlüssen könnte den gegenteiligen Schluss nahelegen. Anhand einer solchen Auswertung wird nun der entsprechende Produktionsparameter so lange angepasst, bis die entsprechende Fehleranzahl des Fehlertyps zurückgeht. Die restlichen fehlerhaften Antennenspulen können dann immer noch, beispielsweise wie mit Bezug auf Fig. 23 beschrieben, nachbearbeitet werden. Auf diese Weise müssen nur wenige Antennenspulen nachbearbeitet werden und der Verbrauch an Material geht deutlich zurück.

Gemäß einer weiteren Variante kann es vorgesehen sein, dass bei einem ersten Druck einer Antennenspule 20 zusätzliche Antennenspulenschleifen oder Bögen 21, 22, 23 gedruckt werden, wie dies in Fig. 24 dargestellt ist. Diese Bögen sind zuerst noch kurzgeschlossen, somit im Wechselstromkreislauf praktisch wirkungslos. Sie wirken weder als zusätzliche Impedanz noch als zusätzliche Kapazität. Mittels des erfindungsgemäßen Prüfverfahrens können nun die wesentlichen Parameter der Antennenspule 20, insbesondere auch deren ohmscher Widerstand (vgl. die vorstehenden Ausführungen mit Bezug auf die Fig. 21 uns 22), bestimmt werden.

In einem weiteren Produktionsschritt kann nun, abhängig von dem im Rahmen des Prüfverfahrens bestimmten Wert, der Widerstand der Antennenspule, falls notwendig, dadurch angepasst werden, dass einer oder mehr als einer der Bögen 21, 22, 23 "geöffnet" wird. Dies kann beispielsweise dadurch erfolgen, dass ein Teil eines den Bogen kurzschließenden Leiterbahnabschnitts herausgestanzt, herausgelasert oder in sonstiger geeigneter Weise entfernt wird, wie dies in Fig. 24 mit dem Bezugszeichen 29 angedeutet ist. Auf diese Weise ist es beispielsweise möglich, Antennenspulen in einem einheitlichen und damit kostengünstigen ersten Produktionsschritt identisch herzustellen und in einem zweiten Produktionsschritt Anpassungen an bestimmte Vorgaben für verschiedene Abnehmer vorzunehmen, beispielsweise bezüglich des ohmschen Widerstandes der jeweiligen Antennenspulen.

Die gezeigten Bögen 21, 22, 23 können auch in anderer Form vorliegen, beispielsweise mäanderförmig. Dies hat den weiteren Vorteil, dass sie auch nach dem Auftrennen des Kurzschlusses des jeweiligen Bogens im Wechselstromkreis ohne Wirkung bleiben.

**Patentansprüche**

1. Verfahren zum Prüfen der Funktionsfähigkeit einer Antennenspule (20) für einen kontaktlos kommunizierenden portablen Datenträger, umfassend die Schritte:

    - Anregen der Antennenspule (20) zur Schwingung;

    **dadurch gekennzeichnet, dass** die Antennenspule (20) induktiv durch einen einzelnen Magnetfeldpuls angeregt wird; und

    - Erfassen der freien, gedämpften Schwingung der Antennenspule (20) in Antwort auf die Anregung;
    - Auswerten der freien gedämpften Schwingung der Antennenspule (20).

2. Verfahren nach Anspruch 1, **dadurch gekennzeichnet, dass** der Magnetfeldpuls durch einen einzelnen Strompuls erzeugt wird.

3. Verfahren nach Anspruch 2, **dadurch gekennzeichnet, dass** der Strompuls als Dirac-Stoß erzeugt wird oder als ein Strompuls, welcher lediglich eine steile Flanke aufweist.

4. Verfahren nach einem der Ansprüche 1 bis 3, **da-**

**durch gekennzeichnet, dass** die Antennenspule (20) mittels einer externen Erregerspule (130) kontaktlos angeregt wird und dass die freie, gedämpfte Schwingung mittels einer externen Messantenne (140) kontaktlos erfasst wird.

5. Verfahren nach Anspruch 4, **dadurch gekennzeichnet, dass** die Erregerspule (130) und die Messantenne (140) zum Prüfen der Antennenspule (20) orthogonal zueinander angeordnet werden.

6. Verfahren nach einem der Ansprüche 1 bis 5, **dadurch gekennzeichnet, dass** beim Auswerten der freien, gedämpften Schwingung der Antennenspule (20) die Resonanzfrequenz der Antennenspule (20) und/oder die Güte der Antennenspule (20) bestimmt werden.

7. Verfahren nach einem der Ansprüche 1 bis 6, **dadurch gekennzeichnet, dass** beim Auswerten der freien gedämpften Schwingung der Antennenspule (20) die Art eines Mangels der Antennenspule (20) festgestellt wird.

8. Verfahren nach Anspruch 7, **dadurch gekennzeichnet, dass** abhängig von der Art des festgestellten Mangels der Antennenspule (20) zumindest ein Produktionsparameter zur Herstellung der Antennenspule (20) neu bestimmt wird und/oder die als mangelhaft erkannte Antennenspule (20) in einem weiteren Schritt nachbearbeitet wird.

9. Verfahren nach einem der Ansprüche 1 bis 8, **dadurch gekennzeichnet, dass** eine Antennenspule (20) ohne angeschlossenen integrierten Schaltkreis (30) und/oder ein Transponder in Form der Antennenspule (20) mit angeschlossenem integrierten Schaltkreis (30) geprüft werden.

10. Verfahren nach einem der Ansprüche 1 bis 9, **dadurch gekennzeichnet,** die Funktionsfähigkeit einer geschlossenen Antennenspule (20) geprüft wird und anschließend eine Leiterbahn der Antennenspule (20) zur Herstellung einer offenen Antennenspule (20) unterbrochen wird, bevor die Antennenspule (20) mit Komponenten eines integrierten Schaltkreises (30), insbesondere einem Chip, verbunden wird.

11. Prüfvorrichtung (100; 100') zum Prüfen der Funktionsfähigkeit einer Antennenspule (20) für einen kontaktlos kommunizierenden portablen Datenträger, umfassend

- eine Einheit (110), welche eingerichtet ist, die Antennenspule (20) über eine an die Einheit (110) angeschlossene Erregerspule (130) kontaktlos zur Schwingung anzuregen;

- eine Messantenne (140); und
- eine Auswertungseinrichtung (160), welche mit der Messantenne (140) verbunden ist;

**dadurch gekennzeichnet, dass**

- die Einheit ein Impulsgeber (110) ist, welcher eingerichtet ist, die Antennenspule (20) mittels eines einzelnen Pulses anzuregen;
- die Messantenne (140) eingerichtet ist, eine freie, gedämpfte Schwingung der Antennenspule (20) kontaktlos zu erfassen; und
- die Auswertungseinrichtung (160) eingerichtet ist, die von der Messantenne (140) erfasste freie, gedämpfte Schwingung auszuwerten.

12. Prüfvorrichtung (100; 100') nach Anspruch 11, **dadurch gekennzeichnet, dass** die Erregerspule (130) und die Messantenne (140) orthogonal zueinander angeordnet sind.

13. Vorrichtung zum Herstellen einer Antennenspule (20) auf einem Trägermaterial (10) für einen kontaktlos kommunizierenden portablen Datenträger, umfassend

- eine Einrichtung zum Herstellen einer Antennenspule (20) auf dem Trägermaterial (10) und
- eine Prüfvorrichtung (100; 100') nach einem der Ansprüche 11 oder 12, insbesondere zum Prüfen der Antennenspule (20) gemäß einem Verfahren nach einem der Ansprüche 1 bis 10.

14. Vorrichtung nach Anspruch 13, **dadurch gekennzeichnet, dass** die Auswertungseinrichtung (160) der Prüfeinrichtung (100; 100') eingerichtet ist, abhängig von der Art eines festgestellten Mangels der Antennenspule (20) zumindest einen Produktionsparameter zur Herstellung der Antennenspule (20) neu zu bestimmen.

15. Vorrichtung nach Anspruch 13 oder 14, **dadurch gekennzeichnet, dass** die Vorrichtung eingerichtet ist, eine nach der Prüfung der Antennenspule (20) durch die Prüfvorrichtung (100; 100') als mangelhaft festgestellte Antennenspule (20) in einem weiteren Schritt nachzubearbeiten.

**Claims**

1. A method for checking the functionality of an antenna coil (20) for a contactlessly communicating portable data carrier, comprising the steps of:

- exciting the antenna coil (20) to oscillate;

**characterized in that**

the antenna coil (20) is excited inductively by one single magnetic field pulse; and

   - detecting the free, damped oscillation of the antenna coil (20) in response to the excitation;
   - evaluating the free damped oscillation of the antenna coil (20).

2. The method according to claim 1, **characterized in that** the magnetic field pulse is generated by one single current pulse.

3. The method according to claim 2, **characterized in that** the current pulse is generated as a Dirac impulse or as a current pulse having only one steep edge.

4. The method according to any of claims 1 to 3, **characterized in that** the antenna coil (20) is excited contactlessly by means of an external exciting coil (130), and that the free, damped oscillation is detected contactlessly by means of an external measuring antenna (140).

5. The method according to claim 4, **characterized in that** the exciting coil (130) and the measuring antenna (140) are disposed orthogonally to each other for checking the antenna coil (20).

6. The method according to any of claims 1 to 5, **characterized in that** upon the evaluation of the free, damped oscillation of the antenna coil (20) the resonance frequency of the antenna coil (20) and/or the quality factor of the antenna coil (20) are determined.

7. The method according to any of claims 1 to 6, **characterized in that** upon the evaluation of the free damped oscillation of the antenna coil (20) the nature of a defect of the antenna coil (20) is ascertained.

8. The method according to claim 7, **characterized in that,** in dependence on the nature of the ascertained defect of the antenna coil (20), at least one production parameter for manufacturing the antenna coil (20) is newly determined and/or the antenna coil (20) recognized as defective is post-processed in a further step.

9. The method according to any of claims 1 to 8, **characterized in that** an antenna coil (20) without an integrated circuit (30) attached and/or a transponder in the form of the antenna coil (20) with an integrated circuit (30) attached are checked.

10. The method according to any of claims 1 to 9, **characterized in that** the functionality of a closed antenna coil (20) is checked and subsequently a conducting path of the antenna coil (20) is interrupted for manufacturing an open antenna coil (20) before the antenna coil (20) is connected to components of an integrated circuit (30), in particular a chip.

11. A checking apparatus (100; 100') for checking the functionality of an antenna coil (20) for a contactlessly communicating portable data carrier, comprising

   - a unit (110) which is arranged to excite the antenna coil (20) to oscillate contactlessly via an exciting coil (130) attached to the unit (110);
   - a measuring antenna (140); and
   - an evaluation device (160) connected to the measuring antenna (140);

**characterized in that**

   - the unit is an impulse generator (110) arranged to excite the antenna coil (20) by means of one single pulse;
   - the measuring antenna (140) is arranged to detect a free, damped oscillation of the antenna coil (20) contactlessly; and
   - the evaluation device (160) is arranged to evaluate the free, damped oscillation detected by the measuring antenna (140).

12. The checking apparatus (100; 100') according to claim 11, **characterized in that** the exciting coil (130) and the measuring antenna (140) are disposed orthogonally to each other.

13. An apparatus for manufacturing an antenna coil (20) on a carrier material (10) for a contactlessly communicating portable data carrier, comprising a device for manufacturing an antenna coil (20) on the carrier material (10), and a checking apparatus (100; 100') according to either of claims 11 or 12, in particular for checking the antenna coil (20) in accordance with a method according to any of claims 1 to 10.

14. The apparatus according to claim 13, **characterized in that** the evaluation device (160) of the checking device (100; 100') is arranged to newly determine at least one production parameter for manufacturing the antenna coil (20) in dependence on the nature of an ascertained defect of the antenna coil (20).

15. The apparatus according to claim 13 or 14, **characterized in that** the apparatus is arranged to post-process, in a further step, an antenna coil (20) ascertained as defective after the check of the antenna coil (20) by the checking apparatus (100; 100').

**Revendications**

1. Procédé de vérification de la capacité de fonctionnement d'une bobine d'antenne (20) pour un support de données portable communiquant sans contact, comprenant les étapes :

   - excitation de la bobine d'antenne (20) de manière à obtenir une oscillation ;

   **caractérisé en ce que**
   la bobine d'antenne (20) est excitée inductivement par une impulsion de champ magnétique individuelle ; et

   - saisie de l'oscillation libre amortie de la bobine d'antenne (20) en réponse à l'excitation ;
   - évaluation de l'oscillation libre amortie de la bobine d'antenne (20).

2. Procédé selon la revendication 1, **caractérisé en ce que** l'impulsion de champ magnétique est générée par une impulsion de courant individuelle.

3. Procédé selon la revendication 2, **caractérisé en ce que** l'impulsion de courant est générée sous forme d'impulsion de Dirac ou d'une impulsion de courant qui présente seulement un flanc raide.

4. Procédé selon une des revendications de 1 à 3, **caractérisé en ce que** la bobine d'antenne (20) est excitée sans contact au moyen d'une bobine externe d'excitation (130) et **en ce que** l'oscillation libre amortie est saisie au moyen d'une antenne externe de mesure (140).

5. Procédé selon la revendication 4, **caractérisé en ce que** la bobine d'excitation (130) et l'antenne de mesure (140) pour la vérification de la bobine d'antenne (20) sont agencées orthogonalement l'une par rapport à l'autre.

6. Procédé selon une des revendications de 1 à 5, **caractérisé en ce que**, lors de l'évaluation de l'oscillation libre amortie de la bobine d'antenne (20), la fréquence de résonance de la bobine d'antenne (20) et/ou la qualité de la bobine d'antenne (20) sont déterminées.

7. Procédé selon une des revendications de 1 à 6, **caractérisé en ce que**, lors de l'évaluation de l'oscillation libre amortie de la bobine d'antenne (20), la nature d'un défaut de la bobine d'antenne (20) est constaté.

8. Procédé selon la revendication 7, **caractérisé en ce que**, en fonction de la nature du défaut constaté de la bobine d'antenne (20), au moins un paramètre de production pour la fabrication de la bobine d'antenne (20) est redéfini et/ou la bobine d'antenne (20) reconnue comme étant défectueuse est, lors d'une autre étape, retouchée.

9. Procédé selon une des revendications de 1 à 8, **caractérisé en ce qu'**une bobine d'antenne (20) sans circuit intégré (30) relié et/ou un transpondeur sous forme d'une bobine d'antenne (20) à circuit intégré (30) relié sont vérifiés.

10. Procédé selon une des revendications de 1 à 9, **caractérisé en ce que** la capacité de fonctionnement d'une bobine d'antenne (20) fermée est vérifiée et que, ensuite, une piste conductrice de la bobine d'antenne (20) est interrompue pour la fabrication d'une bobine d'antenne (20) ouverte avant que la bobine d'antenne (20) ne soit connectée à des composants d'un circuit intégré (30), en particulier à une puce.

11. Dispositif de vérification (100; 100') destiné à de la capacité de fonctionnement d'une bobine d'antenne (20) pour un support de données portable communiquant sans contact, comprenant

   - une unité (110) équipée pour exciter sans contact la bobine d'antenne (20), par l'intermédiaire d'une bobine d'excitation (130) reliée à l'unité (110), de manière à obtenir une oscillation ;
   - une antenne de mesure (140) ; et
   - un équipement d'évaluation (160) connecté à l'antenne de mesure (140) ;

   **caractérisé en ce que**

   - l'unité est un générateur d'impulsions (110) équipé pour exciter la bobine d'antenne (20) au moyen d'une impulsion individuelle ;
   - l'antenne de mesure (140) est équipée pour saisir sans contact une oscillation libre amortie de la bobine d'antenne (20) ; et
   - l'équipement d'évaluation (160) est équipé pour évaluer l'oscillation libre amortie saisie par l'antenne de mesure (140).

12. Dispositif de vérification (100; 100') selon la revendication 11, **caractérisé en ce que** la bobine d'excitation (130) et l'antenne de mesure (140) sont agencées orthogonalement l'une par rapport à l'autre.

13. Dispositif de fabrication d'une bobine d'antenne (20) sur un matériau support (10) pour un support de données portable communiquant sans contact, comprenant

   - un équipement de fabrication d'une bobine d'antenne (20) sur le matériau support (10) et
- un dispositif de vérification (100; 100') selon une des revendications 11 ou 12, en particulier pour la vérification de la bobine d'antenne (20) suivant un procédé selon une des revendications de 1 à 10.

14. Dispositif selon la revendication 13, **caractérisé en ce que** l'équipement d'évaluation (160) du dispositif de vérification (100; 100') est équipé pour, en fonction de la nature d'un défaut constaté de la bobine d'antenne (20), redéfinir au moins un paramètre de production pour la fabrication de la bobine d'antenne (20).

15. Dispositif selon la revendication 13 ou 14, **caractérisé en ce que** le dispositif est équipé pour retoucher lors d'une autre étape une bobine d'antenne (20) apparue comme étant défectueuse lors de la vérification de la bobine d'antenne (20) par le dispositif de vérification (100; 100').

FIG 1

FIG 2

FIG 3

$A_0$

$A = A_0\,e^{-\delta t}$

$A = A_0 \exp(-\delta t)\cos\omega t$

t

FIG 4

100

20

160    150    120    110

140    130

# FIG 5

EP 2 754 086 B1

FIG 6

FIG 7

EP 2 754 086 B1

# FIG 8

FIG 9

EP 2 754 086 B1

| Zeitbasis | Trigger | Anzeige | Cursor | Messung | Mathe | Analyse | Utilities | Hilfe |
|-----------|---------|---------|--------|---------|-------|---------|-----------|-------|

P1:rise(C2)  P2:fall(C2)  P3:period(C2)  P4:freq(C2)  P5:width(C2)  P6: duty(C2)  P7: delay(C2) P8: npoints(C2)
65.40 ns     135.60 ns    ---            ---          ---           ---           ---             500

AC1M
100 mV/div
-2.0 mV ofst
-26.1 mV
-4.8 mV
21.3 mV

| Zeitbasis | -7ns | Trigger | C3 DC |
|-----------|------|---------|-------|
| | 50.0 ns/div | Auto | 292 mV |
| 500 S | 1.0 GS/s | Edge | Negativ |

X1 =  2.5 ns        ΔX=   124.0 ns
X2 =  126.5 ns      1/ΔX = 8.06 MHz

7/12/2011  10:00:35 AM

# FIG 10

| Datei | Vertikal | Zeitbasis | Trigger | Anzeige | Cursor | Messung | Mathe | Analyse | Utilities | Hilfe |

C3

| StdHor | P1:rise(C2) | P2:fall(C2) | P3:period(C2) | P4:freq(C2) | P5:width(C2) | P6: duty(C2) | P7: delay(C2) | P8: npoints(C2) |
|---|---|---|---|---|---|---|---|---|
| value | 103.40 ns | 130.40 ns | --- | | | --- | --- | 500 |
| status | ✗ | ✗ | ✗ | ⚠ | ✗ | ✗ | ⚠ | |

| C1 | BwL | AC1M |
|---|---|---|
| | | 100 mV/div |
| | | -2.0 mV ofst |
| ↓ | | 4.2 mV |
| ↑ | | 9.8 mV |
| Δy | | 5.7 mV |

LeCroy

| Zeitbasis | -7ns | Trigger | C3 | DC |
|---|---|---|---|---|
| | 50.0 ns/div | Auto | | 292 mV |
| 500 S | 1.0 GS/s | Edge | | Negativ |

X1 = 19.5 ns    ΔX = 22.0 nS
X2 = 41.5 ns    1/ΔX = 45 MHz

7/12/2011  9:59:56 AM

# FIG 11

FIG 12

EP 2 754 086 B1

FIG 13

EP 2 754 086 B1

FIG 14

FIG 15

C3

| StdHor | | P1:rise(C2) | P2:fall(C2) | P3:period(C2) | P4:freq(C2) | P5:width(C2) | P6: duty(C2) | P7: delay(C2) | P8: npoints(C2) |
|---|---|---|---|---|---|---|---|---|---|
| value | | 421.65 ns | 36.50 ns | --- | --- | --- | --- | --- | 500 |
| status | | ✕ | ✕ | ✕ | ⚠ | ✕ | ✕ | ⚠ | ✓ |

| C1 | BwL | AC1M |
|---|---|---|
| | | 100 mV/div |
| | | -2.0 mV ofst |
| ↓ | | 63 mV |
| ↑ | | 34.2 mV |
| Δy | | -28.8 mV |

LeCroy

| Zeitbasis | -7ns |
|---|---|
| | 50.0 ns/div |
| 500 S | 1.0 GS/s |

| Trigger | C3 | DC |
|---|---|---|
| Auto | | 76 mV |
| Edge | | Negativ |

X1 = 41.5 ns    ΔX= 23.0 ns
X2 = 64.5 ns    1/ΔX=43.5 MHz

7/13/2011 1:01:44 AM

EP 2 754 086 B1

FIG 16

Datei  Vertikal  Zeitbasis  Trigger  Anzeige  Cursor  Messung  Mathe  Analyse  Utilities  Hilfe

C3

| | P1:rise(C2) | P2:fall(C2) | P3:period(C2) | P4:freq(C2) | P5:width(C2) | P6: duty(C2) | P7: delay(C2) | P8: npoints(C2) |
|---|---|---|---|---|---|---|---|---|
| StdHor value | 319.55 ns | 159.67 ns | --- | --- | --- | --- | --- | 500 |
| status | ✕ | ✕ | ✕ | ⚠ | ✕ | ✕ | ⚠ | ✓ |

| C1 | BwL | AC1M |
|---|---|---|
| | | 100 mV/div |
| | | -2.0 mV ofst |
| ↓ | | 72.8 mV |
| ↑ | | 40.4 mV |
| Δy | | -32.4 mV |

LeCroy

| Zeitbasis | -7ns |
|---|---|
| | 50.0 ns/div |
| 500 S | 1.0 GS/s |

| Trigger | C3 | DC |
|---|---|---|
| Auto | | 76 mV |
| Edge | | Negativ |

X1= 41.5 ns    ΔX= 23.0 ns
X2= 64.5 ns    1/ΔX=43.5 MHz

7/13/2011 1:02:17 AM

EP 2 754 086 B1

FIG 17

EP 2 754 086 B1

# FIG 18

FIG 19

EP 2 754 086 B1

# FIG 20

Referenzspule
(45 MHz, Q1)

Defekte Spule
(80 MHz, Q≪Q1)

Gute Spule
(46 MHz, Q<Q1)

Differenzsignal "defekt"

$s2(t0)-s1(t0)$

Differenzsignal "gut"

$s3(t0)-s1(t0)$

# FIG 21

EP 2 754 086 B1

FIG 22

EP 2 754 086 B1

←
Measure
value
status

| | P1:ampl(C1) | P2:freq(C1) | P3:freq@lv(Z1) | P4:edge@lv(... | P5:freq@lv(Z1) | P6: - - - | P7: - - - | P8: - - - |
|---|---|---|---|---|---|---|---|---|
| | >163.2 mV | --- | | | | | | |
| | ⌘⇑ | ⚠ | | | | | | |

| C1 | BwL | AC1M |
|---|---|---|
| | 20.0 mV/div | |
| | 0.00 mV ofst | |
| ↓ | | -900 µV |
| ↑ | | 9.86 mV |
| Δy | | 10.76 mV |

LeCroy

| Tbase | -200.234 µs | Trigger | C1 AC |
|---|---|---|---|
| | 50.0 ns/div | Auto | 72.4 mV |
| 500 S | 1.0 GS/s | Edge | Positiv |

X1 = 200.1280 µs    ΔX= -68.0 ns
X2 = 200.0600 µs    1/ΔX=-14.7 MHz

7/27/2011  2:50:26 AM

## FIG 23

D1 U1 20 b1

+ 25 b2

D2 U2

=

L

## FIG 24

20

21
19 22
23

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10117249 A1
- DE 102008004772 A1

**In der Beschreibung aufgeführte Nicht-Patentliteratur**

- **KLAUS FINKENZELLER.** RFID-Handbuch. Carl Hanser Verlag, 2008, vol. 5